# EUROPEAN PATENT APPLICATION

(11) **EP 4 329 459 A1**
(43) Date of publication of application: **28.02.2024**
(21) Application number: 23191880.6
(22) Date of filing: 17.08.2023
(51) Int. Cl.: H10K 59/35

(54) **DISPLAY PANEL AND METHOD FOR MANUFACTURING THE SAME**

(30) Priority: 24.08.2022 KR 20220105892
(71) Applicant: Samsung Display Co., Ltd., Yongin-si, Gyeonggi-Do 17113 (KR)
(72) Inventor: JEONG, Da-Hee, Giheung-Gu Yongin-si, Gyeonggi-Do (KR); LEE, Duckjung, Giheung-Gu Yongin-si, Gyeonggi-Do (KR)
(74) Representative: Dr. Weitzel & Partner

(57) **Abstract**

A display panel includes a first unit pixel (UN1), and a second unit pixel (UN2) adjacent to each other in a first direction (DR1). The first unit pixel includes a first light receiving device (OPD1), a (1-1)-th (ED1-1) to a (1-4)-th (ED1-4) light emitting device disposed in a first and a second diagonal direction, a (1-5)-th (ED1-5) and a (1-6)-th (ED1-6) light emitting device disposed in the first direction, and a (1-7)-th (ED1-7) and a (1-8)-th (ED1-8) light emitting device disposed in the second direction (DR2) from the first light receiving device. The second unit pixel includes a second light receiving device (OPD2), a (2-1)-th (ED2-1) to a (2-4)-th (ED2-4) light emitting device disposed in the first and the second diagonal direction (XR1, XR2), a (2-5)-th (ED2-5) and a (2-6)-th (ED2-6) light emitting device disposed in the second direction, and a (2-7)-th (ED2-7) and a (2-8)-th (ED2-8) light emitting device disposed in the first direction from the second light receiving device.

## Description

### BACKGROUND

### 1. Technical Field

The present invention described herein relates to a display panel including a light emitting device and a light receiving region, and a method for manufacturing the same.

### 2. Description of the Related Art

Multimedia electronic apparatuses, such as televisions, cellular phones, tablet computers, navigations, or game consoles, include a display panel to display an image, and an input sensing device to sense an external input. In particular, recently, display devices have a function of sensing the fingerprint of a user.

A method of sensing the fingerprint of a user includes a capacitive method of sensing a change in capacitance formed between electrodes, an optical sensing method of sensing an incident light by using a light sensor, an ultrasonic method of sensing vibration by utilizing a piezoelectric body. Meanwhile, researches and studies have been carried out on the arrangement relationship between a pixel and a sensor based on an optical sensing method, as a sensor based on an optical sensing method is included in a display device layer.

### SUMMARY

Embodiments of the disclosure provide a display panel, capable of preventing a process margin from being reduced or a resolution from being degraded, by adjusting the number of light emitting devices and light receiving devices, and the spacing between the light emitting devices and the light receiving devices, and a method for manufacturing the same.

Embodiments of the disclosure provide a display panel including a light emitting device and a light receiving device formed through a simplified process, and a method for manufacturing the same.

The invention is defined by the independent claims. According to the invention, a display panel includes a first unit pixel, and a second unit pixel disposed adjacent to the first unit pixel in a first direction. The first unit pixel includes a first light receiving device, a (1-1)-th light emitting device and a (1-2)-th light emitting device, each emitting first color light and disposed in a first diagonal direction from the first light receiving device, the first light receiving device disposed between the (1-1)-th light emitting device and the (1-2)-th light emitting device, a (1-3)-th light emitting device and a (1-4)-th light emitting device, each emitting the first color light and disposed in a second diagonal direction intersecting the first diagonal direction from the first light receiving device, the first light receiving device disposed between the (1-3)-th light emitting device and the (1-4)-th light emitting device, a (1-5)-th light emitting device and a (1-6)-th light emitting device, each emitting second color light, disposed in the first direction from the first light receiving device, and interposed between two of the (1-1)-th light emitting device to the (1-4)-th light emitting device, which are arranged in a second direction crossing the first direction, , the first light receiving device disposed between the (1-5)-th light emitting device and the (1-6)-th light emitting device, and a (1-7)-th light emitting device and a (1-8)-th light emitting device, each emitting third color light, disposed in the second direction from the first light receiving device, and interposed between two of the (1-1)-th light emitting device to the (1-4)-th light emitting device, which are arranged in the first direction, the first light receiving device disposed between the (1-7)-th light emitting device and the (1-8)-th light emitting device. The second unit pixel includes a second light receiving device, a (2-1)-th light emitting device and a (2-2)-th light emitting device, each emitting the first color light and disposed in the first diagonal direction from the second light receiving device, the second light receiving device disposed between the (2-1)-th light emitting device and the (2-2)-th light emitting device, a (2-3)-th light emitting device and a (2-4)-th light emitting device, each emitting the first color light and disposed in the second diagonal direction from the second light receiving device, the second light receiving device disposed between the (2-3)-th light emitting device and the (2-4)-th light emitting device, a (2-5)-th light emitting device and a (2-6)-th light emitting device, each emitting the second color light, disposed in the second direction from the second light receiving device, and interposed between two of the (2-1)-th light emitting device to the (2-4)-th light emitting device, which are arranged in the first direction, the second light receiving device disposed between the (2-5)-th light emitting device and the (2-6)-th light emitting device, and a (2-7)-th light emitting device and a (2-8)-th light emitting device, each emitting the third color light, disposed in the first direction from the second light receiving device, and interposed between two of the (2-1)-th light emitting device to the (2-4)-th light emitting device, which are arranged in the second direction, , the second light receiving device disposed between the (2-7)-th light emitting device and the (2-8)-th light emitting device. The (1-2)-th light emitting device is disposed more adjacent to the second unit pixel than the (1-1)-th light emitting device, and one of the (2-3)-th light emitting device and the (2-4)-th light emitting device is disposed most adjacent to the (1-2)-th light emitting device, among the light emitting devices in the second unit pixel.

According to an embodiment, the (1-6)-th light emitting device may be disposed more adjacent to the second unit pixel than the (1-5)-th light emitting device, and one of the (2-7)-th light emitting device and the (2-8)-th light emitting device may be disposed most adjacent to the (1-6)-th light emitting device, among the light emitting devices in the second unit pixel.

According to an embodiment, a number of the first light receiving device may be 1/4 times of a number of the light emitting devices emitting the first color light in the first unit pixel.

According to an embodiment, the (1-1)-th light emitting device may be spaced apart from the first light receiving device by a first spacing, the (1-5)-th light emitting device may be spaced apart from the first light receiving device by a second spacing, the (1-7)-th light emitting device may be spaced apart from the first light receiving device by a third spacing, and the first spacing may be greater than the second spacing and the third spacing.

According to an embodiment, the (1-1)-th light emitting device to the (1-4)-th light emitting device may be spaced apart from the first light receiving device by the first spacing.

According to an embodiment, distances between centers of most adjacent ones of the first light receiving device and the (1-1)-th light emitting device to the (1-8)-th light emitting device may be same, in the first unit pixel.

According to an embodiment, the (1-5)-th light emitting device and the (1-6)-th light emitting device may be symmetrical to each other with respect to the first light receiving device.

According to an embodiment, the (1-7)-th light emitting device and the (1-8)-th light emitting device may be symmetrical to each other with respect to the first light receiving device.

According to an embodiment, a number of the first light receiving device may be 1/2 times of a number of the light emitting devices emitting the second color light in the first unit pixel.

According to an embodiment, each of the (1-1)-th light emitting device to the (1-8)-th light emitting device may include a first electrode, a hole transfer region, an auxiliary layer, a light emitting layer, an electron transfer region, and a second electrode sequentially stacked, and each of the first and second light receiving devices may include a first electrode, a hole transfer region, an auxiliary layer, a light receiving layer, an electron transfer region, and a second electrode sequentially stacked.

According to an embodiment, the auxiliary layer of each of the (1-1)-th light emitting device to the (1-4)-th light emitting device and the auxiliary layer of each of the first and second light receiving device may be integral with each other.

According to an embodiment, the auxiliary layer of each of the (1-5)-th light emitting device and the (1-6)-th light emitting device or the auxiliary layer of each of the (1-7)-th light emitting device and the (1-8)-th light emitting device, and the auxiliary layer of each of the first and second light receiving device may be integral with each other.

According to an embodiment, the display panel may further include a pixel defining layer having an opening part exposing the first electrode of each of the (1-1)-th light emitting device to the (1-8)-th light emitting device, and the opening part exposing the first electrode of at least one of the (1-1)-th light emitting device to the (1-8)-th light emitting device may have a substantially octagonal shape in a plan view

According to an embodiment, the display panel may further include a third unit pixel disposed adjacent to the first unit pixel in the second direction, and a fourth unit pixel disposed adjacent to the second unit pixel in the second direction. The third unit pixel may include a third light receiving device, a (3-1)-th light emitting device and a (3-2)-th light emitting device, each emitting the first color light and disposed in the first diagonal direction from the third light receiving device, the third light receiving device disposed between the (3-1)-th light emitting device and the (3-2)-th light emitting device, a (3-3)-th light emitting device and a (3-4)-th light emitting device, each emitting the first color light and disposed in the second diagonal direction from the third light receiving device, the third light receiving device disposed between the (3-3)-th light emitting device and the (3-4)-th light emitting device, a (3-5)-th light emitting device and a (3-6)-th light emitting device, each emitting the second color light, disposed in the second direction from the third light receiving device, and interposed between two of the (3-1)-th light emitting device to the (3-4)-th light emitting device, which are arranged in the first direction, the third light receiving device disposed between the (3-5)-th light emitting device and the (3-6)-th light emitting device, and a (3-7)-th light emitting device and a (3-8)-th light emitting device, each emitting the third color light, disposed in the first direction from the third light receiving device, and interposed between two of the (3-1)-th light emitting device to the (3-4)-th light emitting device, which are arranged in the second direction, the third light receiving device disposed between the (3-7)-th light emitting device and the (3-8)-th light emitting device. The fourth unit pixel may include a fourth light receiving device, a (4-1)-th light emitting device and a (4-2)-th light emitting device, each emitting the first color light and disposed in the first diagonal direction from the fourth light receiving device, the fourth light receiving device disposed between the (4-1)-th light emitting device and the (4-2)-th light emitting device, a (4-3)-th light emitting device and a (4-4)-th light emitting device, each emitting the first color light and disposed in the second diagonal direction from the fourth light receiving device, the fourth light receiving device disposed between the (4-3)-th light emitting device and the (4-4)-th light emitting device, a (4-5)-th light emitting device and a (4-6)-th light emitting device, each emitting the second color light, disposed in the first direction from the fourth light receiving device, and interposed between two of the (4-1)-th light emitting device to the (4-4)-th light emitting device, which are arranged in the second direction, the fourth light receiving device disposed between the (4-5)-th light emitting device and the (4-6)-th light emitting device, and a (4-7)-th light emitting device and a (4-8)-th light emitting device, each emitting the third color light, disposed in the second direction from the fourth light receiving device, and interposed between two of the (4-1)-th light emitting device to the (4-4)-th light emitting device, which are arranged in the first direction, the fourth light receiving device disposed between the (4-7)-th light emitting device and the (4-8)-th light emitting device.

According to an embodiment, the (3-3)-th light emitting device may be disposed more adjacent to the fourth unit pixel, than the (3-4)-th light emitting device, and one of the (4-1)-th light emitting device and the (4-2)-th light emitting device may be disposed most adjacent to the (3-3)-th light emitting device, among the light emitting devices in the fourth unit pixel.

According to an embodiment, light emitting device, which is most adjacent to light emitting devices emitting the second light in the first unit pixel to the fourth unit pixel, emits the first color light or third color light.

According to the invention, a method for manufacturing a display panel, which includes a first unit pixel, a second unit pixel disposed adjacent to the first unit pixel in a first direction, a third unit pixel disposed adjacent to the first unit pixel in a second direction intersecting the first direction, and a fourth unit pixel disposed adjacent to the second unit pixel in the second direction, in which the first unit pixel includes a first light receiving device, a (1-1)-th light emitting device and a (1-2)-th light emitting device, each emitting first color light and disposed in a first diagonal direction from the first light receiving device, the first light receiving device disposed between the (1-1)-th light emitting device and the (1-2)-th light emitting device, a (1-3)-th light emitting device and a (1-4)-th light emitting device, each emitting the first color light and disposed in a second diagonal direction intersecting the first diagonal direction from the first light receiving device, the first light receiving device disposed between the (1-3)-th light emitting device and the (1-4)-th light emitting device, a (1-5)-th light emitting device and a (1-6)-th light emitting device, each emitting second color light, disposed in the first direction from the first light receiving device, and interposed between two of the (1-1)-th light emitting device to the (1-4)-th light emitting device, which are arranged in a second direction crossing the first direction, the first light receiving device disposed between the (1-5)-th light emitting device and the (1-6)-th light emitting device, and a (1-7)-th light emitting device and a (1-8)-th light emitting device, each emitting third color light, disposed in the second direction from the first light receiving device, and interposed between two of the (1-1)-th light emitting device to the (1-4)-th light emitting device, which are arranged in the first direction, the first light receiving device disposed between the (1-7)-th light emitting device and the (1-8)-th light emitting device, and the second unit pixel includes a second light receiving device a (2-1)-th light emitting device and a (2-2)-th light emitting device, each emitting the first color light and disposed in the first diagonal direction from the second light receiving device, the second light receiving device disposed between the (2-1)-th light emitting device and the (2-2)-th light emitting device, a (2-3)-th light emitting device and a (2-4)-th light emitting device, each emitting the first color light and disposed in the second diagonal direction from the second light receiving device, the second light receiving device disposed between the (2-3)-th light emitting device and the (2-4)-th light emitting device, a (2-5)-th light emitting device and a (2-6)-th light emitting device, each emitting the second color light, disposed in the second direction from the second light receiving device, and interposed between two of the (2-1)-th light emitting device to the (2-4)-th light emitting device, which are arranged in the first direction, the second light receiving device disposed between the (2-5)-th light emitting device and the (2-6)-th light emitting device, and a (2-7)-th light emitting device and a (2-8)-th light emitting device, each emitting the third color light, disposed in the first direction from the second light receiving device, and interposed between two of the (2-1)-th light emitting device to the (2-4)-th light emitting device, which are arranged in the second direction, the second light receiving device disposed between the (2-7)-th light emitting device and the (2-8)-th light emitting device, the method includes providing a working substrate including light receiving electrodes of the first light receiving device and the second light receiving device, first electrodes of the (1-1)-th light emitting device to the (1-8)-th light emitting device, and first electrodes of the (2-1)-th light emitting device to the (2-8)-th light emitting device, depositing, each of auxiliary layers of the first and the second light receiving device on each of the light receiving electrodes, and depositing each of auxiliary layers of the (1-1)-th light emitting device to the (1-4)-th light emitting device and the (2-1)-th light emitting device to the (2-4)-th light emitting device on each of the first electrodes, by using a first mask, simultaneously depositing, on the first electrodes on the working substrate, auxiliary layers of the (1-5)-th light emitting device, the (1-6)-th light emitting device, the (2-5)-th light emitting device, and the (2-6)-th light emitting device by using a second mask, and simultaneously depositing, on the first electrodes on the working substrate, auxiliary layers of the (1-7)-th light emitting device, the (1-8)-th light emitting device, the (2-7)-th light emitting device, and the (2-8)-th light emitting device by using a third mask.

According to an embodiment, the first mask may include first opening parts corresponding to each of the first light receiving device and the second light receiving device, and second opening parts spaced apart from the first opening parts, and the second opening parts may correspond to the (1-1)-th light emitting device to the (1-4)-th light emitting device in the first unit pixel, and the (2-1)-th light emitting device to the (2-4)-th light emitting device in the second unit pixel.

The invention further includes a method for manufacturing a display panel, which includes a first unit pixel, a second unit pixel disposed adjacent to the first unit pixel in a first direction, a third unit pixel disposed adjacent to the first unit pixel in a second direction intersecting the first direction, and a fourth unit pixel disposed adjacent to the second unit pixel in the second direction, in which the first unit pixel includes a first light receiving device, a (1-1)-th light emitting device and a (1-2)-th light emitting device, each emitting first color light and disposed in a first diagonal direction from the first light receiving device, the first light receiving device disposed between the (1-1)-th light emitting device and the (1-2)-th light emitting device, a (1-3)-th light emitting device and a (1-4)-th light emitting device, each emitting the first color light and disposed in a second diagonal direction intersecting the first diagonal direction from the first light receiving device, the first light receiving device disposed between the (1-3)-th light emitting device and the (1-4)-th light emitting device, a (1-5)-th light emitting device and a (1-6)-th light emitting device, each emitting second color light, disposed in the first direction from the first light receiving device, and interposed between two of the (1-1)-th light emitting device to the (1-4)-th light emitting device, which are arranged in the second direction, the first light receiving device disposed between the (1-5)-th light emitting device and the (1-6)-th light emitting device, and a (1-7)-th light emitting device and a (1-8)-th light emitting device, each emitting third color light, disposed in the second direction from the first light receiving device, and interposed between two of the (1-1)-th light emitting device to the (1-4)-th light emitting device, which are arranged in the first direction, the first light receiving device disposed between the (1-7)-th light emitting device and the (1-8)-th light emitting device, and the second unit pixel includes a second light receiving device, a (2-1)-th light emitting device and a (2-2)-th light emitting device, each emitting the first color light and disposed in the first diagonal direction from the second light receiving device, the second light receiving device disposed between the (2-1)-th light emitting device and the (2-2)-th light emitting device, a (2-3)-th light emitting device and a (2-4)-th light emitting device, each emitting the first color light and disposed in the second diagonal direction from the second light receiving device, the second light receiving device disposed between the (2-3)-th light emitting device and the (2-4)-th light emitting device, a (2-5)-th light emitting device and a (2-6)-th light emitting device, each emitting the second color light, disposed in the second direction from the second light receiving device, and interposed between two of the (2-1)-th light emitting device and the (2-4)-th light emitting device, which are arranged in the first direction, the second light receiving device disposed between the (2-5)-th light emitting device and the (2-6)-th light emitting device, and a (2-7)-th light emitting device and a (2-8)-th light emitting device, each emitting the third color light, disposed in the first direction from the second light receiving device, and interposed between two of the (2-1)-th light emitting device to the (2-4)-th light emitting device, which are arranged in the second direction, the second light receiving device disposed between the (2-7)-th light emitting device and the (2-8)-th light emitting device, the method includes providing a working substrate including light receiving electrodes of the first light receiving device and the second light receiving device, first electrodes of the (1-1)-th light emitting device to the (1-8)-th light emitting device, and first electrodes of the (2-1)-th light emitting device to the (2-8)-th light emitting device, simultaneously depositing, on the light receiving electrodes and the first electrodes on the working substrate, auxiliary layers of the first light receiving device and the second light receiving device, auxiliary layers of the (1-7)-th light emitting device, the (1-8)-th light emitting device, the (2-7)-th light emitting device, and the (2-8)-th light emitting device, by using a first mask, simultaneously depositing, on the first electrodes on the working substrate, auxiliary layers of the (1-1)-th light emitting device to the (1-4)-th light emitting device, and the (2-1)-th light emitting device to the (2-4)-th light emitting device by using a second mask, and simultaneously depositing, on the first electrodes on the working substrate, auxiliary layers of the (1-5)-th light emitting device, the (1-6)-th light emitting device, the (2-5)-th light emitting device, and the (2-6)-th light emitting device by using a third mask.

According to an embodiment, the first mask may include a first opening hole corresponding to the first light receiving device, the (1-7)-th light emitting device, and the (1-8)-th light emitting device, and a second opening hole corresponding to the second light receiving device, the (2-7)-th light emitting device, and the (2-8)-th light emitting device. The first opening hole and the second opening hole may have a same shape in a plan view.

### BRIEF DESCRIPTION OF THE DRAWINGS

The above and other objects and features of the disclosure will become apparent by describing embodiments thereof with reference to the accompanying drawings.
FIG. 1 is a perspective view of a display panel according to an embodiment of the disclosure.
FIG. 2 is a schematic cross-sectional view of a display panel according to an embodiment of the disclosure.
FIG. 3 is a plan view illustrating an active region of a display panel, according to an embodiment of the disclosure.
FIG. 4 is an enlarged view of a unit region of FIG. 3.
FIG. 5 is an enlarged view of a first unit pixel and a second unit pixel of FIG. 4.
FIG. 6 is a plan view illustrating the arrangement of a first unit pixel of FIG. 5.
FIG. 7 is a schematic cross-sectional view taken along line I-I' of FIG. 4.
FIG. 8 is a schematic cross-sectional view taken along line II-II' of FIG. 4.
FIG. 9 is an enlarged view of a unit region of FIG. 3 according to an embodiment of the disclosure.
FIG. 10 is a schematic cross-sectional view taken along line III-III' of FIG. 9.
FIGS. 11 to 15 are each an enlarged view of a unit pixel according to an embodiment of the disclosure.
FIG. 16 is a flowchart illustrating a method for manufacturing a display panel according to an embodiment of the disclosure.
FIG. 17 is a schematic cross-sectional view illustrating deposition equipment of a display panel according to an embodiment of the disclosure.
FIG. 18 is a plan view illustrating a partial region of a first mask according to an embodiment of the disclosure.
FIG. 19 is a plan view illustrating a partial region of a second mask according to an embodiment of the disclosure.
FIG. 20 is a plan view illustrating a partial region of a third mask according to an embodiment of the disclosure.
FIG. 21 is a plan view illustrating a partial region of a first mask according to an embodiment of the disclosure.
FIG. 22 is a plan view illustrating a partial region of a second mask according to an embodiment of the disclosure.
FIG. 23 is a plan view illustrating a partial region of a third mask according to an embodiment of the disclosure.

### DETAILED DESCRIPTION OF THE EMBODIMENTS

In the following description, for the purposes of explanation, numerous specific details are set forth in order to provide a thorough understanding of various embodiments or implementations of the disclosure. When an element, such as a layer, is referred to as being "on", "connected to", or "coupled to" another element or layer, it may be directly on, connected to, or coupled to the other element or layer or intervening elements or layers may be present. When, however, an element or layer is referred to as being "directly on", "directly connected to", or "directly coupled to" another element or layer, there are no intervening elements or layers present. To this end, the term "connected" may refer to physical, electrical, and/or fluid connection, with or without intervening elements.

The same reference numeral refers to the same component. In addition, in drawings, thicknesses, proportions, and dimensions of components may be exaggerated to describe the technical features effectively. In the specification and the claims, the phrase "at least one of" is intended to include the meaning of "at least one selected from the group of" for the purpose of its meaning and interpretation. For example, "at least one of A and B" may be understood to mean "A, B, or A and B." The expression "and/or" includes one or more combinations which associated components are capable of defining.

Although the terms "first", "second", etc. may be used to describe various components, the components should not be construed as being limited by the terms. The terms are only used to distinguish one component from another component. For example, without departing from the scope of the disclosure, a first component may be referred to as a second component, and similarly, the second component may be referred to as the first component. The articles "a," "an," and "the" are singular in that they have a single referent, but the use of the singular form in the specification should not preclude the presence of more than one referent.

Also, the terms "under", "below", "on", "above", etc. are used to describe the correlation of components illustrated in drawings. The terms are relative and are described with reference to a direction indicated in the drawing. The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

It will be understood that the terms "include", "comprise", "have", etc. specify the presence of features, numbers, steps, operations, elements, or components, described in the specification, or a combination thereof, not precluding the presence or additional possibility of one or more other features, numbers, steps, operations, elements, or components or a combination thereof.

Unless otherwise defined, all terms (including technical terms and scientific terms) used in the specification have the same meaning as commonly understood by one skilled in the art to which the disclosure belongs. Furthermore, terms such as terms defined in the dictionaries commonly used should be interpreted as having a meaning consistent with the meaning in the context of the related technology, and should not be interpreted in ideal or overly formal meanings unless explicitly defined herein.

Below, embodiments of the disclosure will be described in detail with reference to accompanying drawings.

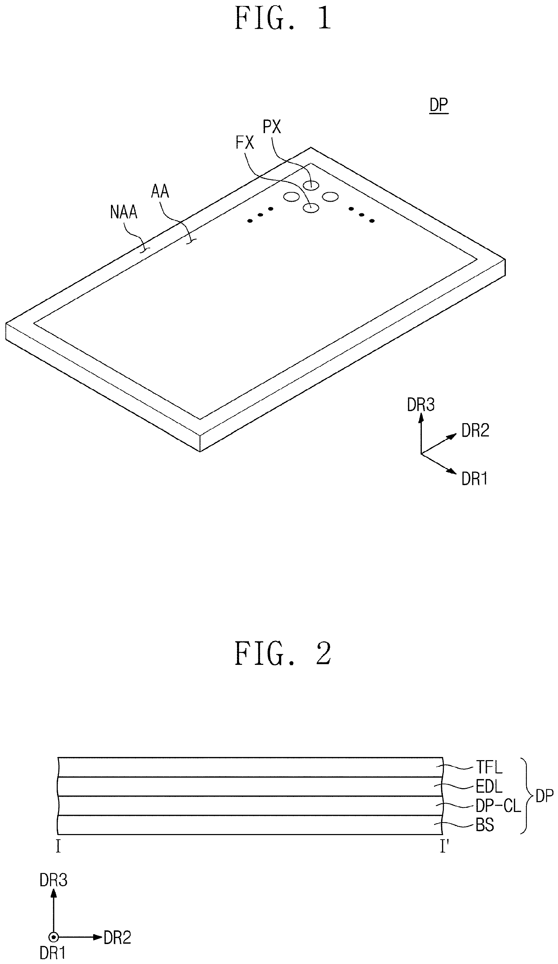

FIG. 1 is a perspective view of a display panel DP according to an embodiment of the disclosure, and FIG. 2 is a schematic cross-sectional view of the display panel DP according to an embodiment of the disclosure.

The display panel DP illustrated in FIGS. 1 and 2 according to an embodiment may be a device activated in response to an electrical signal. For example, the display panel DP may be a cellular phone, a tablet PC, a car navigation system, a game console, or a wearable device, but the disclosure is not limited thereto.

FIG. 1 illustrates a first direction DR1, a second direction DR2, and a third direction DR3. The first direction DR1, the second direction DR2, and the third direction DR3 described in the disclosure may be not limited to three axes of a rectangular coordinate system, such as the x, y, and z axes, and may be interpreted in a broader sense. For example, the first direction DR1, the second direction DR2, and the third direction DR3 may be perpendicular to one another, or may represent different directions that are not perpendicular to one another.

Referring to FIG. 1, the display panel DP may display an image through an active region AA. The active region AA may include a surface defined by a first direction DR1 and a second direction DR2. The active region AA may also include a curved surface that is bent from at least one side of the plane defined by the first direction DR1 and the second direction DR2.

The thickness direction of the display panel DP may be parallel to the third direction DR3 which is a direction of a normal line to the plane defined by the first direction DR1 and the second direction DR2. In this specification, a front surface (or a top surface) and a rear surface (or a bottom surface) of members constituting the display panel DP may be defined based on the third direction DR3.

The image provided on the display panel DP may include a still image as well as a moving picture.

The display panel DP illustrated in FIG. 1 may be divided into the active region AA and a peripheral region NAA. The active region AA may be activated in response to an electrical signal. As described above, the active region AA may be a part that displays an image or detects an external input.

The peripheral region NAA may be a region positioned adjacent to at least one side of the active region AA. The peripheral region NAA may surround the active region AA. However, an embodiment is not limited thereto. For example, according to an embodiment, a portion of the peripheral region NAA may be omitted, which differs from FIG. 1. A driving circuit or driving wires for driving the active region AA may be positioned in the peripheral region NAA.

Light emitting pixels PX and light sensing pixels FX may be disposed in the active region AA of the display panel DP.

The light emitting pixels PX may display an image by applying a driving signal. Multiple light emitting pixels PX may be arranged in the first direction DR1 and the second direction DR2. The light emitting pixels PX may include sub-pixels displaying red color, green color, or blue color.

The light sensing pixels FX may include light receiving devices to convert an optical signal into an electrical signal to detect the optical signal. The light sensing pixels FX may sense the input of a user (for example, to sense the fingerprint of the user).

The display panel DP illustrated in FIG. 2 may include a base layer BS and a display device layer EDL disposed on the base layer BS. The display panel DP may include the base layer BS, a circuit layer DP-CL disposed on the base layer BS, the display device layer EDL disposed on the circuit layer DP-CL, and an encapsulation layer TFL disposed on the display device layer EDL.

The display device layer EDL may include multiple insulating layers, function layers, and conductive layers constituting the light emitting pixels PX. The function layer may include an organic light emitting layer.

The encapsulation layer TFL may cover the display device layer EDL. For example, although not illustrated, the encapsulation layer TFL may also cover the side surface of the display device layer EDL. The encapsulation layer TFL may be omitted depending on the type of the display panel DP or may be substituted a display substrate, depending on the type of the display panel DP.

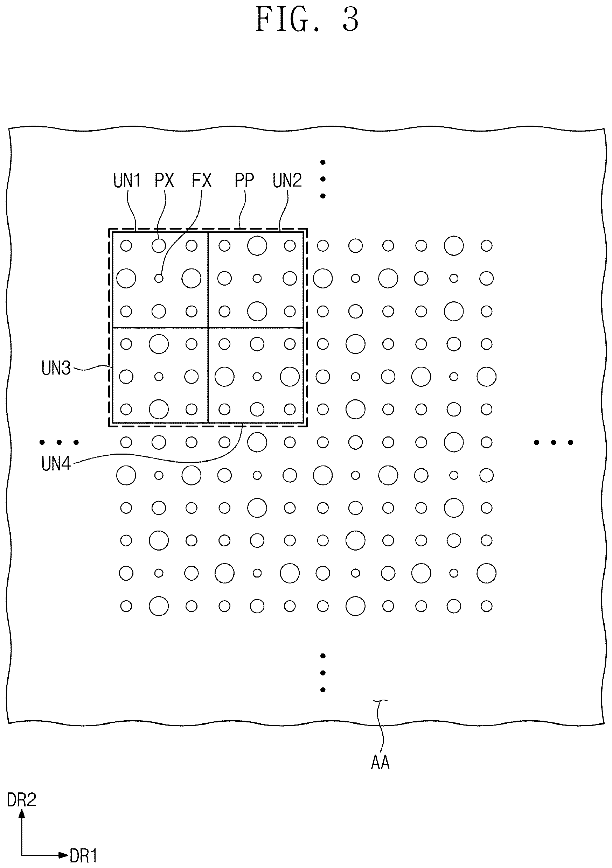

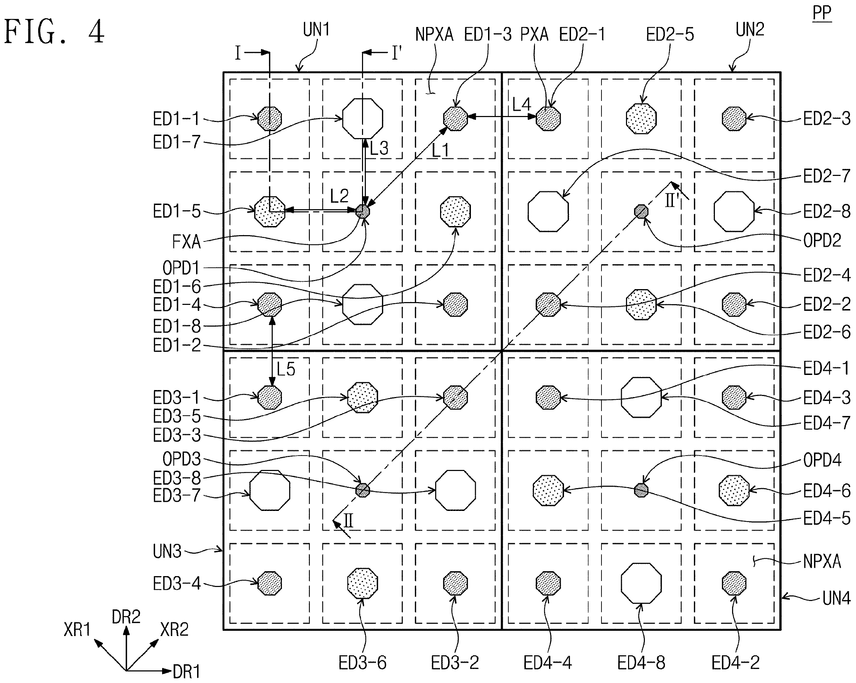

FIG. 3 is a plan view of the active region AA of the display panel DP, according to an embodiment of the disclosure, and FIG. 4 is an enlarged view illustrating the unit region of FIG. 3.

Referring to FIG. 3, according to an embodiment of the disclosure, a unit region PP including the light emitting pixels PX and the light sensing pixels FX may be repeatedly arranged in the active region AA of the display panel DP. The unit region PP may include the light emitting pixels PX and the light sensing pixels FX arranged in the first direction DR1 and the second direction DR2. The unit region PP may be arranged in the first direction DR1 and the second direction DR2 and may constitute the active region AA.

Referring to FIGS. 3 and 4, the unit region PP may include a first unit pixel UN1, a second unit pixel UN2, a third unit pixel UN3, and a fourth unit pixel UN4. Each of the first unit pixel UN1, the second unit pixel UN2, the third unit pixel UN3, and the fourth unit pixel UN4 may include a specific number of light emitting devices and a specific number of light receiving devices arranged in the first direction DR1 and the second direction DR2. The light emitting devices may be disposed in a light emitting region PXA, and the light receiving devices may be disposed in a light sensing region FXA. The light emitting device and the light receiving device may not disposed in the non-light emitting region NPXA.

The first unit pixel UN1 may include a first light receiving device OPD1, an (1-1)-th light emitting device ED1-1, a (1-2)-th light emitting device ED1-2, a (1-3)-th light emitting device ED1-3, an (1-4)-th light emitting device ED1-4, a (1-5)-th light emitting device ED1-5, a (1-6)-th light emitting device ED1-6, an (1-7)-th light emitting device ED1-7, and a (1-8)-th light emitting device ED1-8. The first unit pixel UN1 may be disposed adjacent to the second unit pixel UN2 in the first direction DR1, and may be disposed adjacent to the third unit pixel UN3 in the second direction DR2.

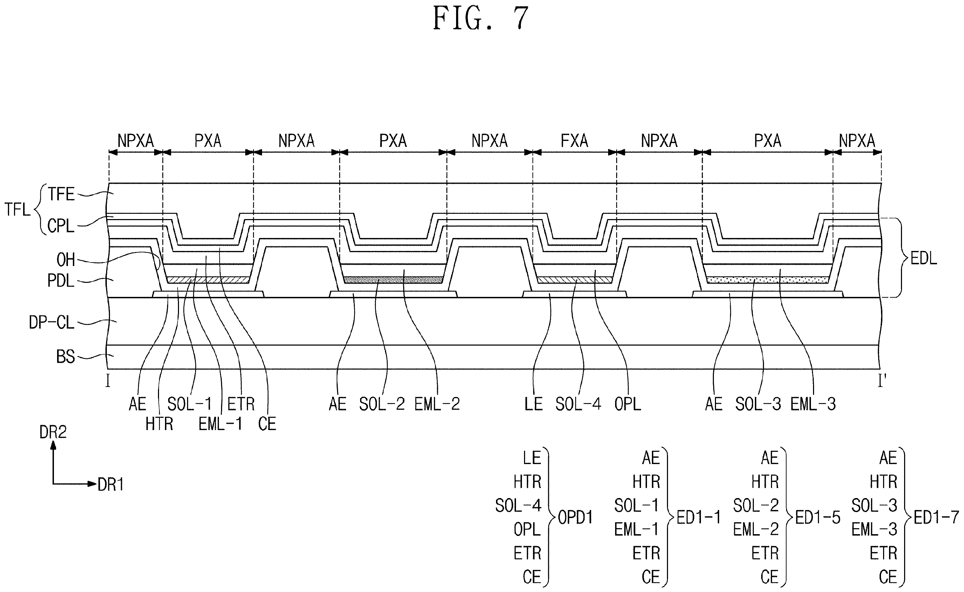

The shape of the first light receiving device OPD1 illustrated in FIG. 4 may be the shape of a light receiving layer OPL disposed in an opening part OH of a pixel defining layer PDL of FIG. 7 in a plan view. The shape of each of the (1-1)-th light emitting device ED1-1 to the (1-8)-th light emitting device ED1-8 illustrated in FIG. 4 may be the shape of each of light emitting layers EML-1 to EML-3 disposed in the opening part OH of the pixel defining layer PDL of FIG. 7 in a plan view. Similarly, the shapes of the light receiving devices OPD1 to OPD4 and the light emitting devices ED1-1 to ED1-8, ED2-1 to ED2-8, ED3-1 to ED3-8, and ED4-1 to ED4-8 may be the shapes of the light receiving layers OPL and the light emitting layers EML1 to EML3 disposed in relevant opening parts OH in a plan view.

The first light receiving device OPD1 may be positioned most adjacent to the center of a region occupied by the first unit pixel UN1. The first light receiving device OPD1 may be positioned in the light sensing region FXA, and may be a portion of the light sensing pixel FX of FIG. 3. The first light receiving device OPD1 may receive light reflected from an external object and incident thereto to sense the light.

The first light receiving device OPD1 may be positioned at the center among the (1-1)-th light emitting device ED1-1 to the (1-8)-th light emitting device ED1-8 to be described below.

The number of first light receiving devices OPD1 may be 1/4 times of the number of light emitting devices that emit first color light in the first unit pixel UN1. In other words, as illustrated in FIG. 4, the first unit pixel UN1 may include one first light receiving device OPD1, and the (1-1)-th light emitting device ED1-1 to the (1-4)-th light emitting device ED1-4 disposed to be spaced apart from each other by a spacing L1 while surrounding the first light receiving device OPD1. Th first color light may be green light.

The number of first light receiving devices OPD1 may be 1/2 times of the number of light emitting devices that emit second color light in the first unit pixel UN1. In other words, as illustrated in FIG. 4, the first unit pixel UN1 may include one first light receiving device OPD1, and the (1-5)-th light emitting device ED1-5 and the (1-6)-th light emitting device ED1-6 disposed in the first direction DR1 from the first light receiving device OPD1, the first light receiving device OPD1 disposed between the (1-5)-th light emitting device ED1-5 and the (1-6)-th light emitting device ED1-6. The second color light may be blue color or red color light.

As described above, since the number of first light receiving devices OPD1 is limited, the first light receiving devices OPD1 may be disposed in the first unit pixel UN1, while maintaining a portion of the light emitting region PXA as much as possible. Also, the spacing between the light emitting devices and the arrangement of the light emitting devices may be not disordered and the resolution may be prevented from being degraded by including additional first light receiving device OPD1.

The (1-1)-th light emitting device ED1-1 and the (1-2)-th light emitting device ED1-2 may be disposed in a first diagonal direction XR1 from the first light receiving device OPD1, the first light receiving device OPD1 disposed between the (1-1)-th light emitting device ED1-1 and the (1-2)-th light emitting device ED1-2. The first diagonal direction XR1 may be a direction crossing the first direction DR1 and the second direction DR2. The first diagonal direction XR1 may be a direction extending from the left-upper portion of the first unit pixel UN1 to the right-lower portion of the first unit pixel UN1 or an opposite direction. The (1-1)-th light emitting device ED1-1 may emit green light which is a first light. The (1-1)-th light emitting device ED1-1 may be a light emitting device positioned at the left-upper portion of the first unit pixel UN1.

The (1-1)-th light emitting device ED1-1 may have an octagonal shape in a plan view. Since the (1-1)-th light emitting device ED1-1 has an octagonal shape, the (1-1)-th light emitting device ED1-1 may maintain a minimum distance to the light emitting devices surrounding the (1-1)-th light emitting device ED1-1, as much as possible. Accordingly, even in case that the area occupied of the first unit pixel UN1 is reduced as the resolution is increased, the (1-1)-th light emitting device ED1-1 may maintain a minimum process margin distance from the adjacent light emitting devices. However, the shape of the (1-1)-th light emitting device ED1-1 is not limited thereto. For example, the (1-1)-th light emitting device ED1-1 may have various shapes such as a rectangle or a parallelogram.

The (1-1)-th light emitting device ED1-1 may be disposed to be spaced apart from the first light receiving device OPD1 by a first spacing L1. The first spacing L1 may be a minimum distance between the (1-1)-th light emitting device ED1-1 and the first light receiving device OPD1. In case that the (1-1)-th light emitting device ED1-1 is spaced apart from the first light receiving device OPD1 by less that the first spacing L1, the green light emitted from the (1-1)-th light emitting device ED1-1 may be reflected by an adjacent layer, and may arrive at the light sensing pixels FX to cause internal light interference. The sensing ability of the light sensing pixels FX may be degraded due to the internal light interference. Accordingly, the (1-1)-th light emitting device ED1-1 emitting the first color light may be disposed farther away from the first light receiving device OPD1, as compared to the light emitting devices that emit the second color light or the third color light. In other words, the first spacing "L1" may be greater than a second spacing L2 and a third spacing L3.

The first spacing L1, which is the minimum distance between the (1-1)-th light emitting device ED1-1 and the first light receiving device OPD1, may be greater than the minimum distance necessary for ensuring ribs between holes of masks for forming the (1-1)-th light emitting device ED1-1 to the (1-4)-th light emitting device ED1-4, and the first light receiving device OPD1. The first spacing L1 may be a spacing sufficient to reduce the internal light interference.

The first spacing L1 may be in the range of about 10 µm to about 50 µm. The first spacing L1 less than 10 µm may make it difficult to ensure ribs of masks for forming the (1-1)-th light emitting device ED1-1 to the (1-8)-th light emitting device ED1-8, and the first light receiving device OPD1. The first spacing L1 less than 10 µm may degrade the sensitivity of the first light receiving device OPD1 due to the internal light interference. The first spacing L1 greater than 50 µm may degrade the resolution of the display panel DP.

The (1-2)-th light emitting device ED1-2 may be disposed in the first diagonal direction XR1 from the first light receiving device OPD1, the first light receiving device OPD1 disposed between the (1-1)-th light emitting device ED1-1 and the (1-2)-th light emitting device ED1-2. The (1-2)-th light emitting device ED1-2 may emit green light which is the first light. The (1-2)-th light emitting device ED1-2 may be positioned at the right-lower portion of the first unit pixel UN1 at opposite ends in the first diagonal direction XR1 from the (1-1)-th light emitting device ED1-1. The (1-2)-th light emitting device ED1-2 may be disposed to be more adjacent to the second unit pixel UN2 than the (1-1)-th light emitting device ED1-1.

The (1-2)-th light emitting device ED1-2 may have an octagonal shape in a plan view, which is similar to the (1-1)-th light emitting device ED1-1. However, the shape of the (1-2)-th light emitting device ED1-2 is not limited thereto. For example, the (1-2)-th light emitting device ED1-2 may have various shapes such as a rectangle or a parallelogram.

The (1-2)-th light emitting device ED1-2 may be disposed to be spaced apart from the first light receiving device OPD1 by the first spacing L1. Since the (1-2)-th light emitting device ED1-2 is spaced apart from the first light receiving device OPD1 by the first spacing L1, which is similar to the (1-1)-th light emitting device ED1-1, the (1-2)-th light emitting device ED1-2 may be symmetrical to the (1-1)-th light emitting device ED1-1 with respect to the first light receiving device OPD1.

The (1-2)-th light emitting device ED1-2 may be disposed farther away from the first light receiving device OPD1, as compared to the light emitting devices that emit the second color light or the third color light, thereby preventing the internal light interference by the first color light similar to the (1-1)-th light emitting device ED1-1.

The (1-3)-th light emitting device ED1-3 may be disposed in a second diagonal direction XR2 crossing the first diagonal direction XR1 from the first light receiving device OPD1, the first light receiving device OPD1 disposed between the (1-3)-th light emitting device ED1-3 and the (1-4)-th light emitting device ED1-4. The second diagonal direction XR2 may be a direction crossing the first direction DR1 and the second direction DR2. The second diagonal direction XR2 may be a direction extending from the left-lower portion of the first unit pixel UN1 to the right-upper portion of the first unit pixel UN1 or an opposite direction. The (1-3)-th light emitting device ED1-3 may emit the first color light. The (1-3)-th light emitting device ED1-3 may be a light emitting device positioned at the right-upper portion of the first unit pixel UN1.

The (1-3)-th light emitting device ED1-3 may have an octagonal shape in a plan view is similar to the (1-1)-th light emitting device ED1-1. However, the shape of the (1-3)-th light emitting device ED1-3 is not limited thereto. For example, the (1-3)-th light emitting device ED1-3 may have various shapes such as a rectangle or a parallelogram.

The (1-3)-th light emitting device ED1-3 may be disposed to be spaced apart from the first light receiving device OPD1 by the first spacing L1.

The (1-4)-th light emitting device ED1-4 may be disposed in the second diagonal direction XR2 crossing the first diagonal direction XR1 from the first light receiving device OPD1, the first light receiving device OPD1 disposed between the (1-4)-th light emitting device ED1-4 and the (1-3)-th light emitting device ED1-3. The (1-4)-th light emitting device ED1-4 may be a light emitting device positioned at the left-lower portion of the first unit pixel UN1. The (1-4)-th light emitting device ED1-4 and the (1-3)-th light emitting device ED1-3 may be symmetrical to each other in the second diagonal direction XR2 with respect to the first light receiving device OPD1

The (1-4)-th light emitting device ED1-4 may emit the first color light similar to the (1-1)-th light emitting device ED1-1 to the (1-3)-th light emitting device ED1-3.

The (1-4)-th light emitting device ED1-4 may have an octagonal shape in a plan view similar to the (1-1)-th light emitting device ED1-1. However, the shape of the (1-4)-th light emitting device ED1-4 is not limited thereto. For example, the (1-4)-th light emitting device ED1-4 may have various shapes such as a rectangle or a parallelogram.

The (1-4)-th light emitting device ED1-4 may be disposed to be spaced apart from the first light receiving device OPD1 by the first spacing L1. The (1-4)-th light emitting device ED1-4 may be spaced apart from the first light receiving device OPD1 by the first spacing L1 and may be symmetrical to the (1-3)-th light emitting device ED1-3.

All of the (1-1)-th light emitting device ED1-1 to the (1-4)-th light emitting device ED1-4 may emit the first color light, and may be disposed to be spaced apart from the first light receiving device OPD1 by the first spacing "L1". The (1-1)-th light emitting device ED1-1 to the (1-4)-th light emitting device ED1-4 may be spaced apart from each other by a same spacing while surrounding the first light receiving device OPD1. The (1-1)-th light emitting device ED1-1 to the (1-4)-th light emitting device ED1-4 may be positioned to be adjacent to corners of the first unit pixel UN1.

The size of each of the (1-1)-th light emitting device ED1-1 to the (1-4)-th light emitting device ED1-4 may be smaller than the size of each of the (1-5)-th light emitting device ED1-5 and the (1-6)-th light emitting device ED1-6 emitting the second color light and the size of each of the (1-7)-th light emitting device ED1-7 and the (1-8)-th light emitting device ED1-8 emitting the third color light.

The (1-5)-th light emitting device ED1-5 may be disposed in the first direction DR1 from the first light receiving device OPD1, the first light receiving device OPD1 disposed between the (1-5)-th light emitting device ED1-5 and the (1-6)-th light emitting device ED1-6. The (1-5)-th light emitting device ED1-5 may emit the second color light. The second color light may be a blue light or red light. The (1-5)-th light emitting device ED1-5 may be a light emitting device positioned at the left side of the first light receiving device OPD1 in the first unit pixel UN1.

The (1-5)-th light emitting device ED1-5 may have an octagonal shape in a plan view. However, the shape of the (1-5)-th light emitting device ED1-5 is not limited thereto. For example, the (1-5)-th light emitting device ED1-5 may have various shapes such as a rectangle or a parallelogram.

The (1-5)-th light emitting device ED1-5 may be disposed to be spaced apart from the first light receiving device OPD1 by the second spacing L2. The second spacing "L2" may be a minimum distance between the (1-5)-th light emitting device ED1-5 and the first light receiving device OPD1. The light emitted from the (1-5)-th light emitting device ED1-5 may cause less internal light interference with the first light receiving device OPD1, as compared to the green color light, which is the first color light. According to an embodiment, the separation of the (1-5)-th light emitting device ED1-5 from the first light receiving device OPD1 may be less as compared to the separation of the (1-1)-th light emitting device ED1-1 to the (1-4)-th light emitting device ED1-4 emitting the first color light from the first light receiving device OPD1. Accordingly, the second spacing L2 may be less than the first spacing "L1".

The second spacing L2, which is the minimum distance between the (1-5)-th light emitting device ED1-5 and the first light receiving device OPD1, may be a spacing enough to reduce the internal light interference.

The second spacing L2 may be in the range of about 10 µm to about 40 µm. The second spacing L2 less than 10 µm may make it difficult to ensure the area for forming the ribs of masks for forming the light emitting devices. The sensing ability of the first light receiving device OPD1 may be degraded due to the internal light interference. The second spacing L2 greater than 40 µm may degrade the resolution of the display panel DP.

The (1-5)-th light emitting device ED1-5 may be interposed between two light emitting devices, which are arranged in the second direction DR2 crossing the first direction DR1, of the (1-1)-th light emitting device ED1-1 to the (1-4)-th light emitting device ED1-4. For example, the (1-5)-th light emitting device ED1-5 may be interposed between the (1-1)-th light emitting device ED1-1 and the (1-4)-th light emitting device ED1-4.

The (1-6)-th light emitting device ED1-6 may be disposed in the first direction DR1 from the first light receiving device OPD1, the first light receiving device OPD1 disposed between the (1-6)-th light emitting device ED1-6 and the (1-5)-th light emitting device ED1-5. The (1-6)-th light emitting device ED1-6 may emit the second color light which the same color light as that of the (1-5)-th light emitting device ED1-5. The (1-6)-th light emitting device ED1-6 may be a light emitting device positioned at the right side of the first light receiving device OPD1 in the first unit pixel UN1.

The (1-6)-th light emitting device ED1-6 may have an octagonal shape in a plan view. However, the shape of the (1-6)-th light emitting device ED1-6 is not limited thereto. For example, the (1-6)-th light emitting device ED1-6 may have various shapes.

The (1-6)-th light emitting device ED1-6 may be disposed to be spaced apart from the first light receiving device OPD1 by the second spacing L2. The (1-6)-th light emitting device ED1-6 may be interposed between the (1-3)-th light emitting device ED1-3 and the (1-2)-th light emitting device ED1-2.

The (1-5)-th light emitting device ED1-5 and the (1-6)-th light emitting device ED1-6 may be spaced apart from the first light receiving device OPD1 by the second spacing L2 and may be symmetrical to each other with respect to the first light receiving device OPD1, and may emit the same second color light.

The (1-5)-th light emitting device ED1-5, the (1-6)-th light emitting device ED1-6, and the first light receiving device OPD1 may be arranged colinearly in the first direction DR1. However, the positions of the (1-5)-th light emitting device ED1-5 and the (1-6)-th light emitting device ED1-6 are not limited thereto, and may be changed in the range of the second spacing L2 provided above from the first light receiving device OPD1.

The (1-7)-th light emitting device ED1-7 may be disposed in the second direction DR2 from the first light receiving device OPD1, the first light receiving device OPD1 disposed between the (1-7)-th light emitting device ED1-7 and the (1-8)-th light emitting device ED1-8. The (1-7)-th light emitting device ED1-7 may emit the third color light. The third color light may be blue light or red light, and may be color different from the second color light. The (1-7)-th light emitting device ED1-7 may be a light emitting device positioned at the upper side of the first light receiving device OPD1 in the first unit pixel UN 1.

The (1-7)-th light emitting device ED1-7 may have an octagonal shape in a plan view. However, the shape of the (1-7)-th light emitting device ED1-7 is not limited thereto. For example, the (1-7)-th light emitting device ED1-7 may have various shapes.

The (1-7)-th light emitting device ED1-7 may be positioned to be spaced apart from the first light receiving device OPD1 by the third spacing L3. The third spacing L3 may be a minimum distance between the (1-7)-th light emitting device ED1-7 and the first light receiving device OPD1. The light emitted from the (1-7)-th light emitting device ED1-7 may cause less internal light interference with the light receiving device FX, as compared to the green light which is the first color light. According to an embodiment, the (1-7)-th light emitting device ED1-7 may require less spacing from the first light receiving device OPD1, as compared to the (1-1)-th light emitting device ED1-1 to the (1-4)-th light emitting device ED1-4 emitting the first color light. Accordingly, the third spacing L3 may be less than the first spacing L1.

The third spacing L3, which is the minimum distance between the (1-7)-th light emitting device ED1-7 and the first light receiving device OPD1, may be a spacing enough to reduce the internal light interference with the first light receiving device OPD1.

The third spacing L3 may be in the range of about 10 µm to about 40 µm. The third spacing L3 less than 10 µm may make it difficult to ensure the area for forming the ribs of masks for forming the light emitting devices. The sensing ability of the first light receiving device OPD1 may be degraded due to the internal light interference. The third spacing L3 greater than 40 µm may degrade the resolution of the display panel DP.

The (1-7)-th light emitting device ED1-7 may be interposed between two light emitting devices, which are arranged in the first direction DR1, of the (1-1)-th light emitting device ED1-1 to the (1-4)-th light emitting device ED1-4. The (1-7)-th light emitting device ED1-7 may be interposed between the (1-1)-th light emitting device ED1-1 and the (1-3)-th light emitting device ED1-3.

The (1-8)-th light emitting device ED1-8 may be disposed in the second direction DR2 from the first light receiving device OPD1, the first light receiving device OPD1 disposed between the (1-7)-th light emitting device ED1-7 and the (1-8)-th light emitting device ED1-8. The (1-8)-th light emitting device ED1-8 may emit the third color light. The (1-8)-th light emitting device ED1-8 may be a light emitting device positioned at the lower side of the first light receiving device OPD1 in the first unit pixel UN1.

The (1-8)-th light emitting device ED1-8 may have an octagonal shape in a plan view. However, the shape of the (1-8)-th light emitting device ED1-8 is not limited thereto. For example, the (1-8)-th light emitting device ED1-8 may have various shapes.

The (1-8)-th light emitting device ED1-8 may be disposed to be spaced apart from the first light receiving device OPD1 by the third spacing L3.

The (1-7)-th light emitting device ED1-7 and the (1-8)-th light emitting device ED1-8 may be spaced apart from the first light receiving device OPD1 by the third spacing L3 and may be symmetrical to each other with respect to the first light receiving device OPD1 .

The (1-7)-th light emitting device ED1-7, the (1-8)-th light emitting device ED1-8, and the first light receiving device OPD1 may be arranged colinearly in the second direction DR2. However, the positions of the (1-7)-th light emitting device ED1-7 and the (1-8)-th light emitting device ED1-8 are not limited thereto, and may be changed in the range of the third spacing L3 provided above from the first light receiving device OPD1.

The (1-8)-th light emitting device ED1-8 may be disposed in the second direction DR2 from the first light receiving device OPD1, the first light receiving device OPD1 disposed between the (1-7)-th light emitting device ED1-7 and the (1-8)-th light emitting device ED1-8. The (1-8)-th light emitting device ED1-8 may emit the third color light. The (1-8)-th light emitting device ED1-8 may be a light emitting device positioned at the lower side of the first light receiving device OPD1 in the first unit pixel UN1.

The (1-8)-th light emitting device ED1-8 may have an octagonal shape in a plan view. However, the shape of the (1-8)-th light emitting device ED1-8 is not limited thereto. For example, the (1-8)-th light emitting device ED1-8 may have various shapes.

The (1-8)-th light emitting device ED1-8 may be disposed to be spaced apart from the first light receiving device OPD1 by the third spacing L3.

The (1-8)-th light emitting device ED1-8 may be interposed between two light emitting devices, which are arranged in the first direction DR1, of the (1-1)-th light emitting device ED1-1 to the (1-4)-th light emitting device ED1-4. The (1-8)-th light emitting device ED1-8 may be interposed between the (1-2)-th light emitting device ED1-2 and the (1-4)-th light emitting device ED1-4.

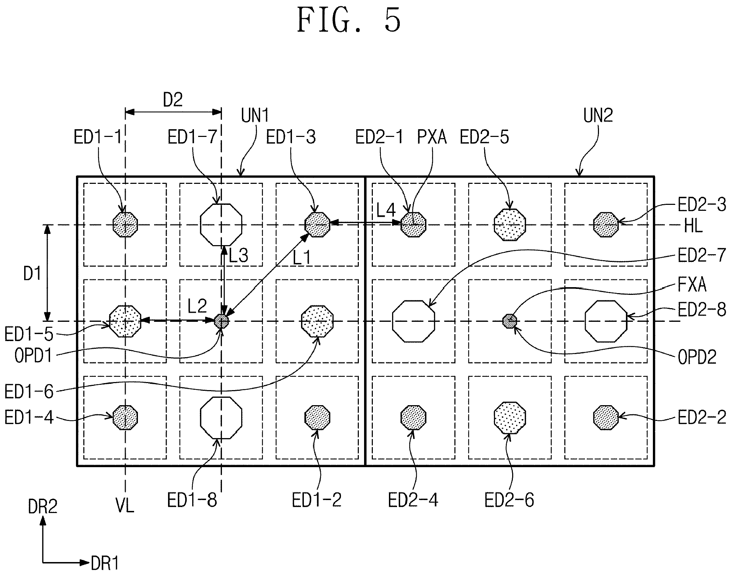

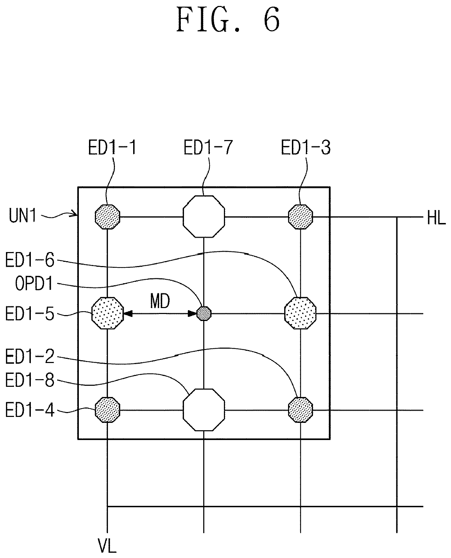

FIG. 5 is an enlarged view of the first unit pixel and the second unit pixel of FIG. 4, and FIG. 6 is a plan view illustrating the arrangement of the first unit pixel of FIG. 5.

Referring to FIGS. 5 and 6, the first light receiving device OPD1 of the first unit pixel UN1 and the (1-1)-th light emitting device ED1-1 to the (1-8)-th light emitting device ED1-8 may be positioned at crossing points between vertical lines VL and horizontal lines HL each spaced apart from each other by a spacing. As long as the first light receiving device OPD1 and the (1-1)-th light emitting device ED1-1 to the (1-8)-th light emitting device ED1-8 are generally positioned at crossing points between vertical lines VL and horizontal lines HL, a center of each of the first light receiving device OPD1 and the (1-1)-th light emitting device ED1-1 to the (1-8)-th light emitting device ED1-8 may slightly deviate from the crossing between the vertical lines VL and the horizontal lines HL.

The horizontal lines HL may be spaced apart from each other by a first distance D1 in the second direction DR2. The vertical lines VL may be spaced apart from each other by a second distance D2 in the first direction DR1. The first distance D1 and the second distance D2 may be equal. In another embodiment, the first distance D1 and the second distance D2 may be changed depending on the necessary arrangement of the first unit pixel UN1, and the first distance D1 and the second distance D2 may be different.

A minimum spacing between the first light receiving device OPD1 of the first unit pixel UN1 and each of the (1-1)-th light emitting device ED1-1 to the (1-8)-th light emitting device ED1-8 may be at least the minimum spacing to ensure the ribs of the masks.

Referring to FIGS. 4 and 5, the second unit pixel UN2 may include a second light receiving device OPD2, a (2-1)-th light emitting device ED2-1, a (2-2)-th light emitting device ED2-2, a (2-3)-th light emitting device ED2-3, a (2-4)-th light emitting device ED2-4, a (2-5)-th light emitting device ED2-5, a (2-6)-th light emitting device ED2-6, a (2-7)-th light emitting device ED2-7, and a (2-8)-th light emitting device ED2-8. The second unit pixel UN2 may be disposed adjacent to the first unit pixel UN1 in the first direction DR1, and may be disposed adjacent to the fourth unit pixel UN4 in the second direction DR2.

The spacing between most adjacent light emitting devices emitting the first color light in the first unit pixel UN1 and the second unit pixel UN2 may be a fourth spacing L4. In other words, the (2-1)-th light emitting device ED2-1 may be disposed to be spaced apart from the (1-3)-th light emitting device ED1-3 by the fourth spacing L4. The fourth spacing L4 may be in the range of about 10 µm to about 100 µm. The fourth spacing L4 less than 10 µm may make it difficult to ensure the area for forming the ribs of masks for forming the light emitting devices. The fourth spacing L4 greater than 100 µm may degrade the resolution of the display panel DP.

The second unit pixel UN2 may have similar light emitting devices arrangement to the first unit pixel UN1 except for the arrangement of the (2-5)-th light emitting device ED2-5, the (2-6)-th light emitting device ED2-6, the (2-7)-th light emitting device ED2-7, and the (2-8)-th light emitting device ED2-8.

The second light receiving device OPD2 and the (2-1)-th light emitting device ED2-1 to the (2-4)-th light emitting device ED2-4 in the second unit pixel UN2 may have the same arrangement structure as those of the first light receiving device OPD1 and the (1-1)-th light emitting device ED1-1 to the (1-4)-th light emitting device ED1-4 in the first unit pixel UN1, so the details thereof will be omitted.

The (2-5)-th light emitting device ED2-5 may be positioned, in the second unit pixel UN2, to correspond to the (1-7)-th light emitting device ED1-7 in the first unit pixel UN1, and may emit light having color different from that of the (1-7)-th light emitting device ED1-7. In other words, the (2-5)-th light emitting device ED2-5 may be disposed in the second direction DR2 from the second light receiving device OPD2, the second light receiving device OPD2 disposed between the (2-5)-th light emitting device ED2-5 and the (2-6)-th light emitting device ED2-6, and may emit the second color light. The second color light may have the same color as that of light emitted from the (1-5)-th light emitting device ED1-5 and the (1-6)-th light emitting device ED1-6 in the first unit pixel UN1.

The (2-5)-th light emitting device ED2-5 may have an octagonal shape in a plan view. However, the shape of the (2-5)-th light emitting device ED2-5 is not limited thereto. For example, the (2-5)-th light emitting device ED2-5 may have various shapes.

The (2-6)-th light emitting device ED2-6 may be positioned, in the second unit pixel UN2, to correspond to the (1-8)-th light emitting device ED1-8 in the first unit pixel UN1, and may emit light having color different from that of the (1-8)-th light emitting device ED1-8. In other words, the (2-6)-th light emitting device ED2-6 may be disposed in the second direction DR2 from the second light receiving device OPD2, the second light receiving device OPD2 disposed between the (2-5)-th light emitting device ED2-5 and the (2-6)-th light emitting device ED2-6.

The (2-6)-th light emitting device ED2-6 may have an octagonal shape in a plan view. However, the shape of the (2-6)-th light emitting device ED2-6 is not limited thereto. For example, the (2-6)-th light emitting device ED2-6 may have various shapes.

The (2-7)-th light emitting device ED2-7 may be positioned, in the second unit pixel UN2, to correspond to the (1-5)-th light emitting device ED1-5 in the first unit pixel UN1, and may emit light having color different from that of the (1-5)-th light emitting device ED1-5. In other words, the (2-7)-th light emitting device ED2-7 may be disposed in the first direction DR1 from the second light receiving device OPD2, the second light receiving device OPD2 disposed between the (2-7)-th light emitting device ED2-7 and the (2-8)-th light emitting device ED2-8. The third color light may have the same color as that of light emitted from the (1-7)-th light emitting device ED1-7 and the (1-8)-th light emitting device ED1-8 in the first unit pixel UN1.

The (2-7)-th light emitting device ED2-7 may have an octagonal shape in a plan view. However, the shape of the (2-7)-th light emitting device ED2-7 is not limited thereto. For example, the (2-7)-th light emitting device ED2-7 may have various shapes.

The (2-8)-th light emitting device ED2-8 may be positioned, in the second unit pixel UN2, to correspond to the (1-6)-th light emitting device ED1-6 in the first unit pixel UN1, and may emit light having color different from that of the (1-6)-th light emitting device ED1-6. In other words, the (2-8)-th light emitting device ED2-8 may be disposed in the first direction DR1 from the second light receiving device OPD2, the second light receiving device OPD2 disposed between the (2-8)-th light emitting device ED2-8 and the (2-7)-th light emitting device ED2-7.

In the first unit pixel UN1 and the second unit pixel UN2, the light emitting devices emitting the first color light may be disposed adjacent to each other. This is because the visibility of resolution is not degraded, even in case that the distance between the light emitting devices that emit the first color light is less than the distance between the light emitting devices that emit the second color light or the third color light, as the light emitting device that emit the first color light is smaller than the light emitting devices that emit the second color light or the third color light.

In other words, the (1-3)-th light emitting device ED1-3 in the first unit pixel UN1 may be disposed adjacent to the (2-1)-th light emitting device ED2-1 in the second unit pixel UN2 in the first direction DR1. Accordingly, the (1-3)-th light emitting device ED1-3 and the (2-1)-th light emitting device ED2-1 may emit the first color light. In other words, the (1-2)-th light emitting device ED1-2 in the first unit pixel UN1 may be disposed adjacent to the (2-4)-th light emitting device ED2-4 in the second unit pixel UN2 in the first direction DR1. Accordingly, the (1-2)-th light emitting device ED1-2 and the (2-4)-th light emitting device ED2-4 may emit the first color light.

The light emitting devices that emit the second color light and the third color light in the first unit pixel UN1 may not be disposed adjacent to the light emitting devices that emit the same color light in the second unit pixel UN2. This is because the visibility of resolution may be degraded, in case that the light emitting devices that emit the second color light and the third color light has a shorter distance than that of the light emitting devices that emit the first color light, as the light emitting devices that emit the second color light and the third color light are larger than the light emitting devices that emit the first color light in size.

In other words, the (1-6)-th light emitting device ED1-6 in the first unit pixel UN1 may be disposed adjacent to the (2-7)-th light emitting device ED2-7 in the second unit pixel UN2 in the first direction DR1. Accordingly, the (1-6)-th light emitting device ED1-6 and the (2-7)-th light emitting device ED2-7 may emit the second color light and the third color light.

The third unit pixel UN3 may be disposed adjacent to the first unit pixel UN1 in the second direction DR2, and may be disposed adjacent to the fourth unit pixel UN4 in the first direction DR1. The spacing between most adjacent light emitting devices that emit the first color light in the second direction DR2 in the first unit pixel UN1 and the third unit pixel UN3 may be a fifth spacing L5. In other words, the (1-4)-th light emitting device ED1-4 may be disposed to be spaced apart from a (3-1)-th light emitting device ED3-1 in the second direction DR2 by the fifth spacing L5. The fifth spacing L5 may be in the range of about 10 µm to about 100 µm. The fifth spacing L5 less than 10 µm may make it difficult to ensure the area for forming the ribs of masks for forming the light emitting devices. The fifth spacing L5 greater than 100 µm may degrade the resolution of the display panel DP.

The third unit pixel UN3 may have the same arrangement structure as that of the second unit pixel UN2.

In other words, the third light receiving device OPD3 and the (3-1)-th light emitting device ED3-1 to a (3-4)-th light emitting device ED3-4 may have the same arrangement structure as those of the second light receiving device OPD2 and the (2-1)-th light emitting device ED2-1 to the (2-4)-th light emitting device ED2-4. A (3-5)-th light emitting device ED3-5 and a (3-6)-th light emitting device ED3-6 may have the same arrangement structures of the (2-5)-th light emitting device ED2-5 and the (2-6)-th light emitting device ED2-6. A (3-7)-th light emitting device ED3-7 and a (3-8)-th light emitting device ED3-8 may have the same arrangement structures of the (2-7)-th light emitting device ED2-7 and the (2-8)-th light emitting device ED2-8.

The fourth unit pixel UN4 may be disposed adjacent to the second unit pixel UN2 in the second direction DR2, and may be disposed adjacent to the third unit pixel UN3 in the first direction DR1.

The fourth unit pixel UN4 may have the same arrangement structure as that of the first unit pixel UN1.

In other words, a fourth light receiving device OPD4 and a (4-1)-th light emitting device ED4-1 to a (4-4)-th light emitting device ED4-4 may have the same arrangement structure as those of the first light receiving device OPD1 and the (1-1)-th light emitting device ED1-1 to the (1-4)-th light emitting device ED1-4. A (4-5)-th light emitting device ED4-5 and a (4-6)-th light emitting device ED4-6 may have the same arrangement structures of the (1-5)-th light emitting device ED1-5 and the (1-6)-th light emitting device ED1-6. A (4-7)-th light emitting device ED4-7 and a (4-8)-th light emitting device ED4-8 may have the same arrangement structures of the (1-7)-th light emitting device ED1-7 and the (1-8)-th light emitting device ED1-8.

In the first unit pixel UN1, the second unit pixel UN2, the third unit pixel UN3, and the fourth unit pixel UN4, the (1-2)-th light emitting device ED1-2, the (2-4)-th light emitting device ED2-4, a (3-3)-th light emitting device ED3-3, and the (4-1)-th light emitting device ED4-1 may be disposed adjacent to each other.

The (1-4)-th light emitting device ED1-4 may be disposed adjacent to the (3-1)-th light emitting device ED3-1 in the second direction DR2, and the (2-2)-th light emitting device ED2-2 may be disposed adjacent to a (4-3)-th light emitting device ED4-3 in the second direction DR2. The (1-3)-th light emitting device ED1-3 may be disposed adjacent to the (2-1)-th light emitting device ED2-1 in the first direction DR1, and a (3-2)-th light emitting device ED3-2 may be disposed adjacent to the (4-4)-th light emitting device ED4-4 in the first direction DR1.

As described above, the light emitting devices in the first unit pixel UN1 to the fourth unit pixel UN4 that emit the first color light may be disposed adjacent to the light emitting devices that emit the first color light in a different unit pixel, in the first direction DR1 and the second direction DR2.

To the contrary, the light emitting devices in the first unit pixel UN1 to the fourth unit pixel UN4 that emit the second color light or the third color light may not be disposed adjacent to the light emitting devices that emit the same color. For example, the (1-6)-th light emitting device ED1-6 that emit the second color light may be disposed adjacent to the (2-7)-th light emitting device ED2-7 in the first direction DR1, and may be disposed adjacent to the (1-3)-th light emitting device ED1-3 and the (1-2)-th light emitting device ED1-2 in the second direction DR2. The (1-2)-th light emitting device ED1-2 and the (1-3)-th light emitting device ED1-3 adjacent to the (1-6)-th light emitting device ED1-6 may emit the first color light, and the (2-7)-th light emitting device ED2-7 may emit the third color light.

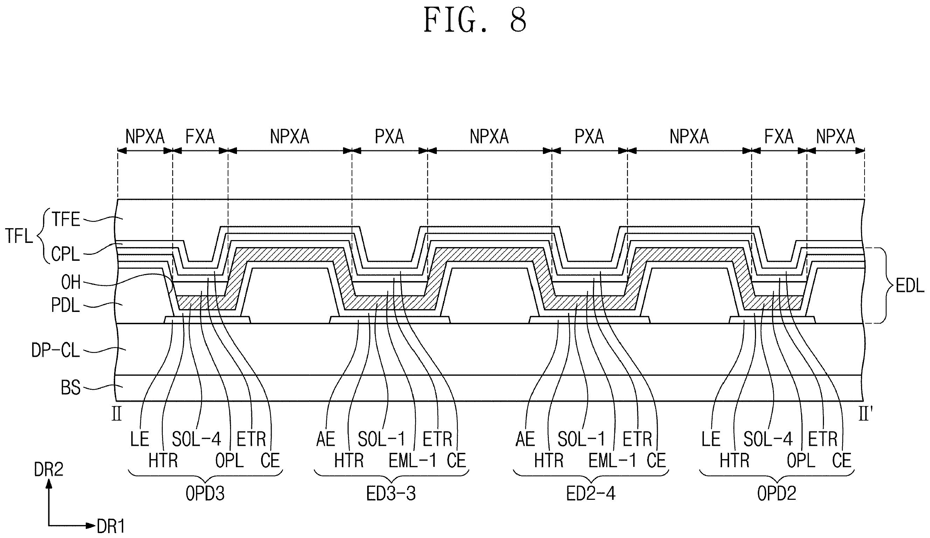

FIG. 7 is a schematic cross-sectional view taken along line I-I' of FIG. 4, and FIG. 8 is a schematic cross-sectional view taken along line II-II' of FIG. 4.

Referring to FIG. 7, the (1-1)-th light emitting device ED1-1 may be disposed in the opening part OH defined in the pixel defining layer PDL. The opening part OH may expose a light receiving electrode LE and a first electrode AE of each of the light emitting devices ED1-1 to ED1-8, and ED2-1 to ED2-8 and the light receiving devices OPD1 and OPD2 of FIG. 4.

The shape of the opening part OH may be substantially octagonal in a plan view (see FIGS. 4 and 7). The wording "substantially octagonal" may refer to a mathematical concept that includes an octagon and an octagon with a curved vertex, and the angle of the vertex may be varied depending on the etching rate of the insulating layer. However, the shape of the opening part OH in a plan view is not limited thereto. For example, the opening part OH may have various shapes.

The encapsulation layer TFL including a capping layer CPL and a thin film encapsulation TFE may be disposed on the (1-1)-th light emitting device ED1-1.

The (1-1)-th light emitting device ED1-1 may include the first electrode AE, a hole transport region HTR, also called as hole transfer region HTR, a first auxiliary layer SOL-1, a first light emitting layer EML-1, an electron transport region ETR, also called as electron transfer region ETR, and a second electrode CE sequentially stacked. Although not specifically illustrated in the drawings, the (1-2)-th light emitting device ED1-2 to the (1-8)-th light emitting device ED1-8 may have the same stack structure except for materials of the auxiliary layer and the light emitting layer.

The auxiliary layer and the light emitting layer of the light emitting devices that emit the same color light may be deposited through a same process, thus may have a same auxiliary layer and a same light emitting layer. According to an embodiment of the disclosure, the light emitting devices that emit the first color light may include the first auxiliary layer SOL-1 and the first light emitting layer EML-1, the light emitting devices that emit the second color light may include a second auxiliary layer SOL-2 and a second light emitting layer EML-2, and the light emitting devices that emit the third color light may include a third auxiliary layer SOL-3 and a third light emitting layer EML-3. In another embodiment, light emitting devices that emits same color light may include different auxiliary layers and different light emitting layers. If necessary, different auxiliary layers and different light emitting layers may be utilized.

The auxiliary layer and the light receiving layer of the light receiving devices may be deposited through a same process. Accordingly, the light receiving devices may have a same auxiliary layer and a same light receiving layer. According to an embodiment of the disclosure, light emitting devices including a fourth auxiliary layer SOL-4 and the light receiving layer OPL may be provided. In another embodiment, light receiving devices may include different auxiliary layers and different light receiving layers. If necessary, different auxiliary layers and different light receiving layers may be utilized.

For example, the (1-5)-th light emitting device ED1-5 may have the structure in which the first electrode AE, a hole transfer layer HTR, the second auxiliary layer SOL-2, the second light emitting layer EML-2, an electron transfer layer ETR, and the second electrode CE are sequentially stacked on each other. The (1-7)-th light emitting device ED1-7 may have the structure in which the first electrode AE, the hole transport region HTR, the third auxiliary layer SOL-3, the third light emitting layer EML-3, the electron transport region ETR, and the second electrode CE are sequentially stacked on each other. The hole transport region HTR may also be called as hole transfer region HTR. The hole transport region HTR may also be called as electron transfer region ETR.

The first light receiving device OPD1 may include the light receiving electrode LE, the hole transport region HTR, the fourth auxiliary layer SOL-4, the light receiving layer OPL, the electron transport region ETR, also be called as a hole transport region HTR, and the second electrode CE sequentially stacked on each other.

As shown in FIG. 7, the first to fourth auxiliary layers SOL-1, SOL-2, SOL-3, and SOL-4 may not be a common layer.

Referring to FIG. 8, the first auxiliary layer SOL-1 and the fourth auxiliary layer SOL-4 may be integral with each other and may be a common layer. In other words, the auxiliary layers of the (3-3)-th light emitting device ED3-3 and the (2-4)-th light emitting device ED2-4 that emit the first color light and the auxiliary layers of the second light receiving device OPD2 and the third light receiving device OPD3 may be integral with each other and may be a common layer. Although not illustrated in FIG. 8, the auxiliary layers of the light receiving devices of the first unit pixel UN1 to the fourth unit pixel UN4 and the auxiliary layers of the light emitting devices that emit the first color light may be integral with each other and may be a common layer.

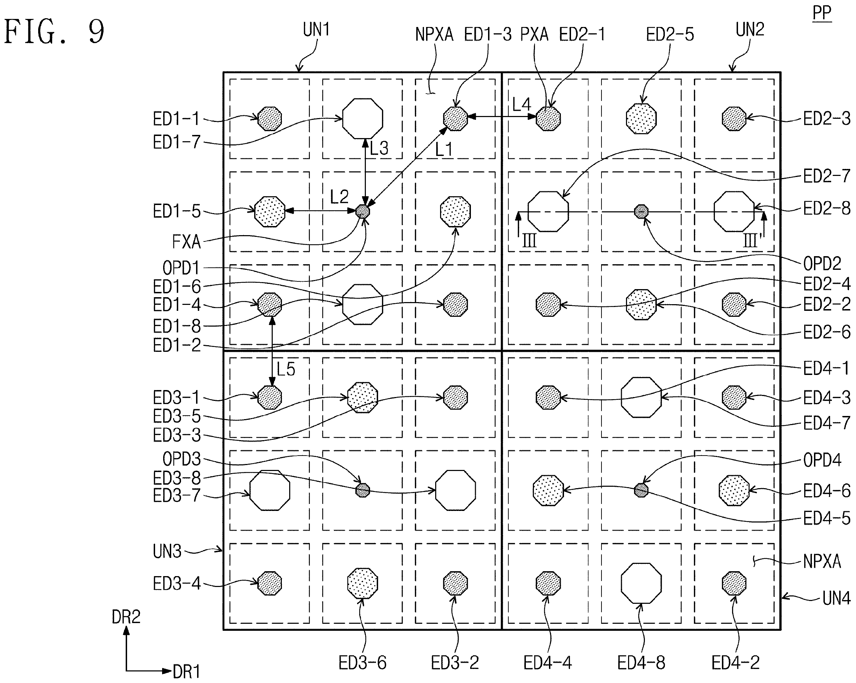

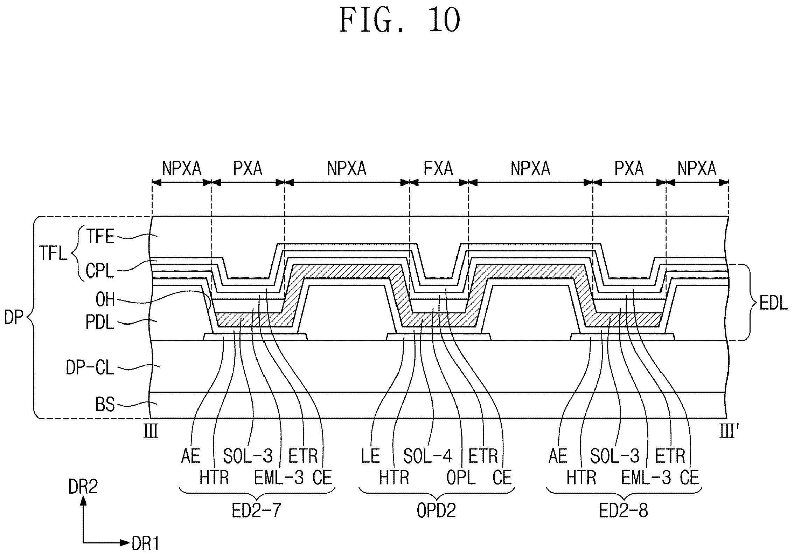

FIG. 9 is an enlarged view of the unit region of FIG. 3, according to an embodiment of the disclosure, and FIG. 10 is a schematic cross-sectional view taken along line III-III' of FIG 9.

The light emitting devices and the light receiving devices of FIG. 9 are the same as the light emitting devices and the light receiving devices of FIG. 4 except for the arrangement of auxiliary layers. Accordingly, the duplication of the description of the same components will be omitted to avoid redundancy.

Referring to FIG. 10, the third auxiliary layer SOL-3 of the (2-7)-th light emitting device ED2-7, the fourth auxiliary layer SOL-4 of the second light receiving device OPD2, and the third auxiliary layer SOL-3 of the (2-8)-th light emitting device ED2-8 may be integral with each other and may be a common layer. Although not illustrated in FIG. 10, the auxiliary layers of the light receiving devices of the first unit pixel UN1 to the fourth unit pixel UN4 and the auxiliary layers of the light emitting devices that emit the third color light may be integral with each other and may be a common layer.

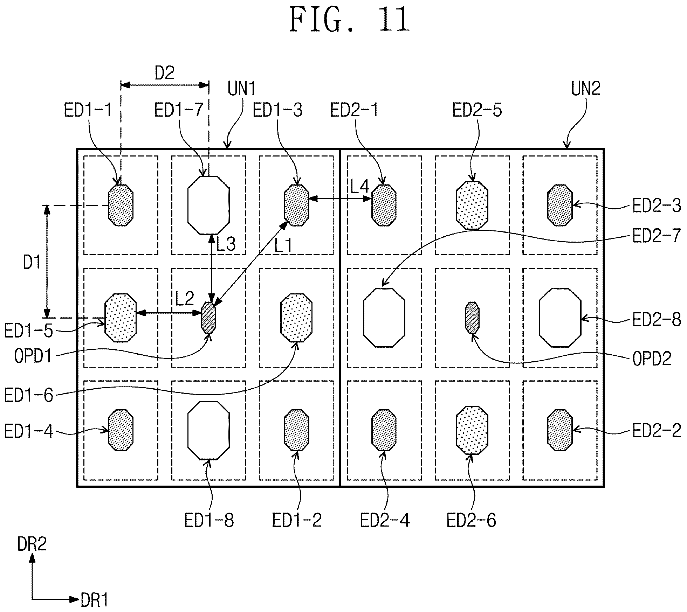

FIGS. 11 to 15 are each an enlarged view of a unit pixel according to an embodiment of the disclosure.

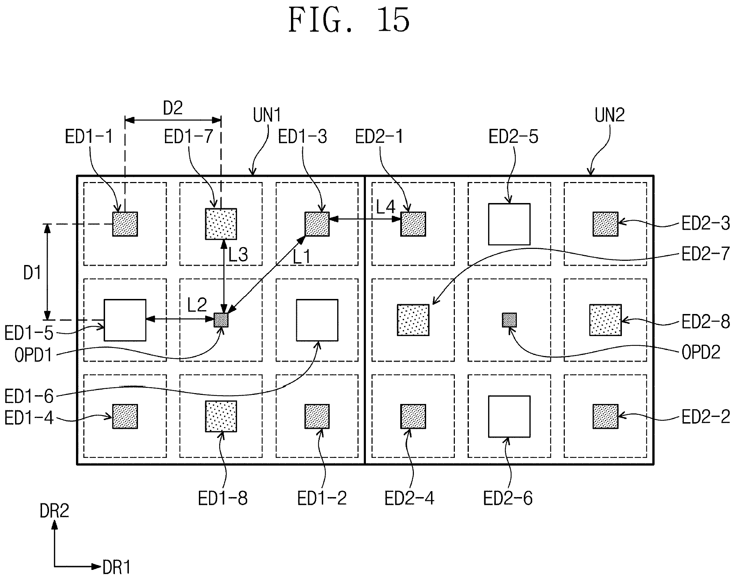

FIGS. 11 and 15 illustrate the same light emitting devices ED1-1 to ED1-8, and ED2-1 to ED2-8 and the light receiving devices OPD1 and OPD2 as those illustrated in FIG. 5, except for the shape and the arrangement of the light emitting devices ED1-1 to ED1-8, and ED2-1 to ED2-8 and the light receiving devices OPD1 and OPD2, so the description of the same components will be omitted to avoid redundancy.

Referring to FIG. 11, a distance between the centers of the light emitting devices ED1-1 to ED1-8, and ED2-1 to ED2-8, and the centers of the light receiving devices OPD1 and OPD2 in the second direction DR2 may be the first distance D1. A distance between the centers of the light emitting devices ED1-1 to ED1-8, and ED2-1 to ED2-8, and the centers of the light receiving devices OPD1 and OPD2 in the first direction DR1 may be the second distance D2. The first distance D1 may be greater than the second distance D2.

Although the shapes of the light emitting devices ED1-1 to ED1-8, and ED2-1 to ED2-8 are maintained, in case that the second distance D2 becomes less than the first distance D1, the second spacing L2 and the fourth spacing L4 in the first direction DR1 may be reduced. Thus, in the shape of the light emitting devices ED1-1 to ED1-8, and ED2-1 to ED2-8 and the shape of the light receiving devices OPD1 and OPD2, the width in the first direction DR1 may be decreased, and the width in the second direction DR2 may be increased. Accordingly, the first spacing L1 to the fourth spacing L4 may be maintained.

As described above, in case that the shapes of the light emitting devices ED1-1 to ED1-8, and ED2-1 to ED2-8 and the shapes of the light receiving devices OPD1 and OPD2 are changed, even in case that the second distance D2 becomes less than the first distance D1, the minimum spacing between the light emitting devices ED1-1 to ED1-8, and ED2-1 to ED2-8 and the light receiving devices OPD1 and OPD2 may be maintained, such that the space for ensuring the ribs of the masks may be provided.

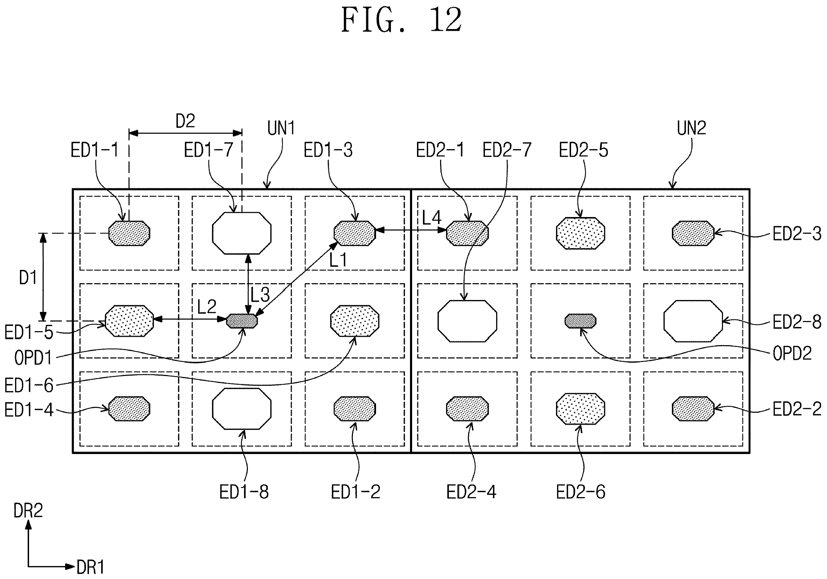

Referring to FIG. 12, the first distance D1 may be less than the second distance D2. In the shape of the light emitting devices ED1-1 to ED1-8, and ED2-1 to ED2-8 and the light receiving devices OPD1 and OPD2, the width in the first direction DR1 may be increased, and the width in the second direction DR2 may be decreased. Accordingly, the first spacing L1 to the fourth spacing L4 may be maintained without change.

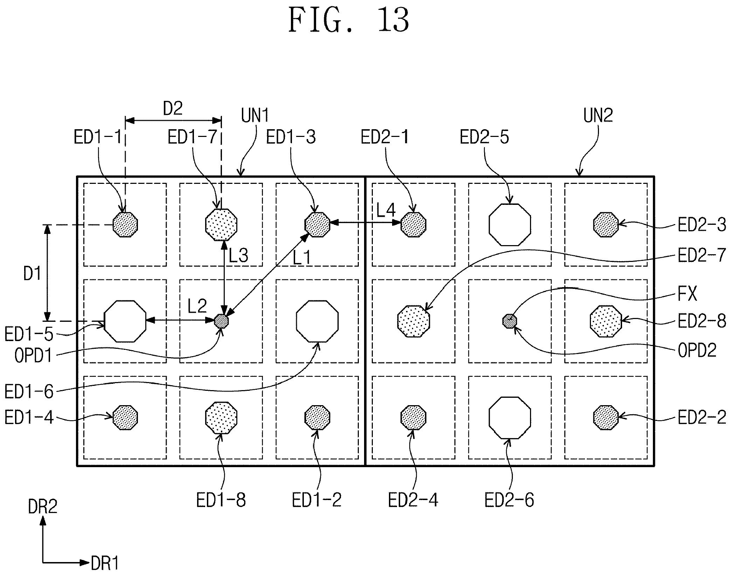

Referring to FIG. 13, the (1-5)-th light emitting device ED1-5, the (1-6)-th light emitting device ED1-6, the (2-5)-th light emitting device ED2-5, and the (2-6)-th light emitting device ED2-6 may emit the third color light, and the (1-7)-th light emitting device ED1-7, the (1-8)-th light emitting device ED1-8, the (2-7)-th light emitting device ED2-7, and the (2-8)-th light emitting device ED2-8 may emit the second color light.

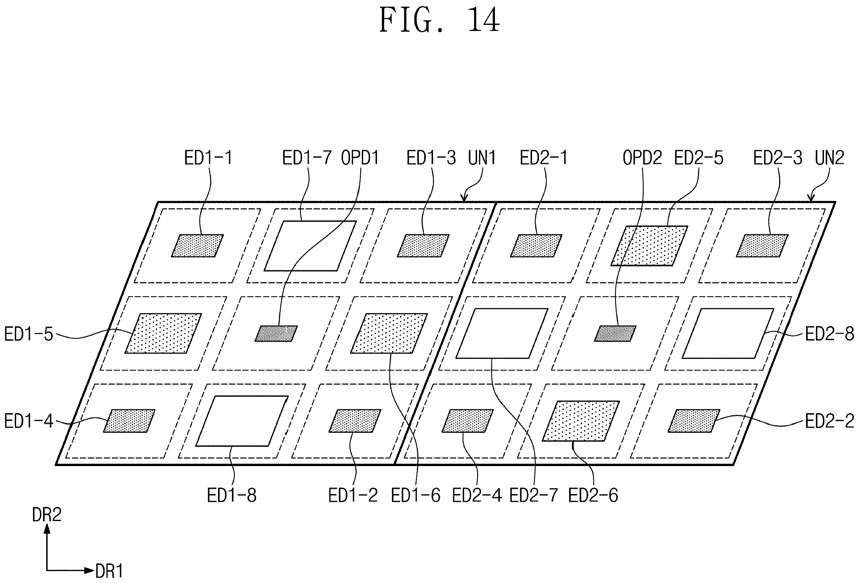

Referring to FIG. 14, the first unit pixel UN1 and the second unit pixel UN2 may have a parallel quadrilateral shape in a plan view. Accordingly, the shape of the light emitting devices ED1-1 to ED1-8, and ED2-1 to ED2-8 and the shape of the light receiving devices OPD1 and OPD2 may be changed to the parallel quadrilateral shape, so the minimum spacing between the light emitting devices ED1-1 to ED1-8, and ED2-1 to ED2-8 and the light receiving devices OPD1 and OPD2 may be maintained without change.

Referring to FIG. 15, in a plan view, the light emitting devices ED1-1 to ED1-8, and ED2-1 to ED2-8 and the light receiving devices OPD1 and OPD2 may have a rectangular shape, instead of an octagonal shape. However, the shapes of the light emitting devices ED1-1 to ED1-8, and ED2-1 to ED2-8 and the shapes of the light receiving devices OPD1 and OPD2 in a plan view are not limited thereto, but may have various shapes.

Hereinafter, a method for manufacturing the display panel DP according to an embodiment of the disclosure will be described.

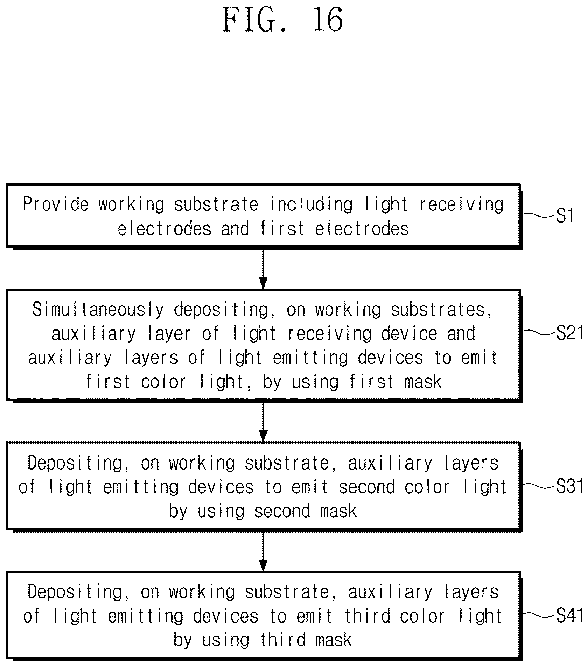

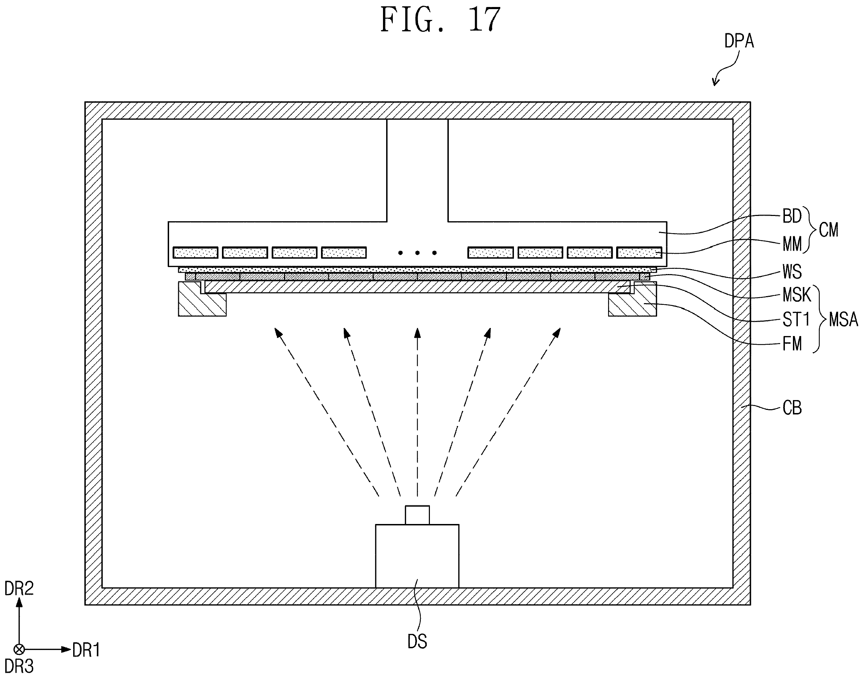

FIG. 16 is a flowchart illustrating a method for manufacturing a display panel, according to an embodiment of the disclosure. FIG. 17 is a schematic cross-sectional view illustrating deposition equipment of a display panel, according to an embodiment of the disclosure.

The display panel DP to be described below may have the same components as those of the display panel DP described above. Accordingly, the same reference numeral will be assigned to the same components, and the details thereof will be omitted.

Referring to FIGS. 16 and 17, to manufacture the display panel DP, a working substrate WS including the light receiving electrode LE of the light receiving devices OPD1 to OPD4 and the first electrodes AE of the light emitting devices ED1-1 to ED1-8, ED2-1 to ED2-8, ED3-1 to ED3-8, and ED4-1 to ED4-8 may be provided (S1).

The auxiliary layers SOL-1 and SOL-4 (see FIG. 8) of the light receiving devices OPD1 to OPD4 and the light emitting devices ED1-1 to ED1-4, ED2-1 to ED2-4, ED3-1 to ED3-4, and ED4-1 to ED4-4, which emit the first color light, may be simultaneously deposited using a first mask MSK1 (S21). The details of the first mask MSK1 will be described below. The simultaneously-deposited auxiliary layers SOL-1 and SOL-4 (see FIG. 8) of the light receiving devices OPD1 to OPD4 and the light emitting devices ED1-1 to ED1-4, ED2-1 to ED2-4, ED3-1 to ED3-4, and ED4-1 to ED4-4 emitting the first color light may be deposited in the form of a common layer by using a same depositing material.

As the auxiliary layers SOL-1 and SOL-4 (see FIG. 8) of light receiving devices OPD1 to OPD4 and the light emitting devices ED1-1 to ED1-4, ED2-1 to ED2-4, ED3-1 to ED3-4, and ED4-1 to ED4-4, which emit the first color light, are simultaneously deposited by using the first mask MSK1, the manufacturing process of the display panel DP may be simplified to reduce the manufacturing costs and the manufacturing time.

However, in step S21, the auxiliary layer stacked simultaneously with the fourth auxiliary layer SOL-4 of the light receiving devices OPD1 to OPD4 is not limited only to the first auxiliary layer SOL-1. In other words, the fourth auxiliary layer SOL-4 and the second auxiliary layer SOL-2 or the third auxiliary layer SOL-3 of the light receiving devices OPD1 to OPD4 may be simultaneously stacked. In S31 and S41 which are subsequent steps, an auxiliary layer not deposited in S21, which is the present step, among the first auxiliary layer to the third auxiliary layer SOL-1 to SOL-3 may be deposited by using a second mask MSK2 and a third mask MSK3 to be described below.

The second auxiliary layer SOL-2 (see FIG. 7) of the light emitting devices ED1-5, ED1-6, ED2-5, ED2-6, ED3-5, ED3-6, ED4-5, and ED4-6 may be simultaneously deposited on the working substrate WS using the second mask MSK2 (S31). The third auxiliary layer SOL-3 (see FIG. 7) of the light emitting devices ED1-7, ED1-8, ED2-7, ED2-8, ED3-7, ED3-8, ED4-7, and ED4-8 may be simultaneously deposited on the working substrate WS using the third mask MSK3 (S41). The details of the shapes of the second mask MSK2 and the third mask MSK3 will be described below.

Referring to FIG. 17, a deposition equipment DPA may be used during the deposition process of the display panel DP of FIG. 1. The deposition equipment DPA may include a deposition chamber CB, a fixing member CM, a deposition source DS, and a mask assembly MSA. Although not illustrated in FIG. 17, the deposition equipment DPA may include an additional machinery device to have an in-line system.

The deposition chamber CB may set the deposition condition to vacuum. The deposition chamber CB may include a bottom surface, a ceiling surface, and sidewalls. The bottom surface of the deposition chamber CB may be parallel to a plane defined by the first direction DR1 and the second direction DR2. A normal direction to the bottom surface of the deposition chamber CB is indicated in the third direction DR3.

The fixing member CM may be disposed inside the deposition chamber CB, may be disposed on the deposition source DS, and may fix the mask assembly MSA. The fixing member CM may be mounted on the ceiling surface of the deposition chamber CB. The fixing member CM may include a jig or a robot arm holding the mask assembly MSA.

The fixing member CM may include a body part BD and magnetic bodies MM coupled to the body part BD. The body part BD may include a plate serving as a basic structure to fix the mask assembly MSA, but is not limited thereto. The magnetic bodies MM may be disposed inside or outside the body part BD. The magnetic bodies MM may fix the mask assembly MSA by magnetic force.

The deposition source DS may evaporate a deposition material, such as a light emitting material, and may provide the deposition material in the form of deposition vapor. The deposition vapor may pass through the mask assembly MSA and may be deposited to the working substrate WS forming a specific pattern.

The mask assembly MSA may be disposed inside the deposition chamber CB, and may be deposited on the deposition source DS to support the working substrate WS. The working substrate WS may be a glass substrate or a plastic substrate. The working substrate WS may include a polymer layer disposed on the base substrate. The base substrate may be removed later in the second half of the manufacturing process of the display panel.

The mask assembly MSA may include a frame FM, multiple sticks ST1, and multiple masks MSK. Although the mask assembly MSA including one type of sticks ST1 extending in a same direction is illustrated according to an embodiment, the mask assembly MSA may include a different type of sticks extending in another direction according to an embodiment of the disclosure.

The masks MSK may be disposed on the frame FM, and the sticks ST1, may extend in the first direction DR1, and may be arranged in the second direction DR2. The masks MSK may include invar having a smaller thermal expansion coefficient than that of the frame FM. The masks MSK may include, for example, nickel (Ni), the nickel-cobalt alloy, or the nickel-iron alloy.

The masks MSK may be welded to and coupled to the frame FM. In the process of manufacturing the mask assembly MSA, the masks MSK may be welded to the frame FM while each of the masks MSK is stretched in the second direction DR2. The mask assembly MSA may include multiple masks MSK segmented. The masks MSK may be subject to less sagging, as compared to one large-size mask corresponding to the frame FM.

The masks may include the first masks MSK1, the second masks MSK2, and the third masks MSK3.

The frame FM may have a rectangular shape in a plan view. The frame FM may include a metal. The frame FM may include, for example, nickel (Ni), the nickel-cobalt alloy, or the nickel-iron alloy.

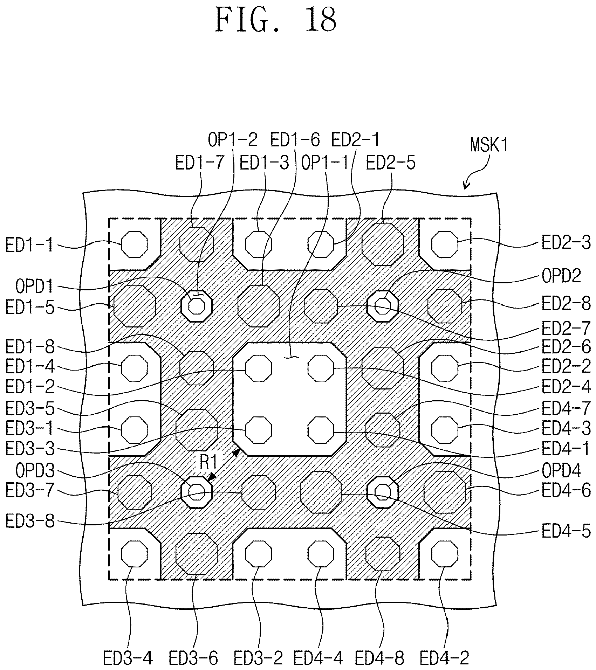

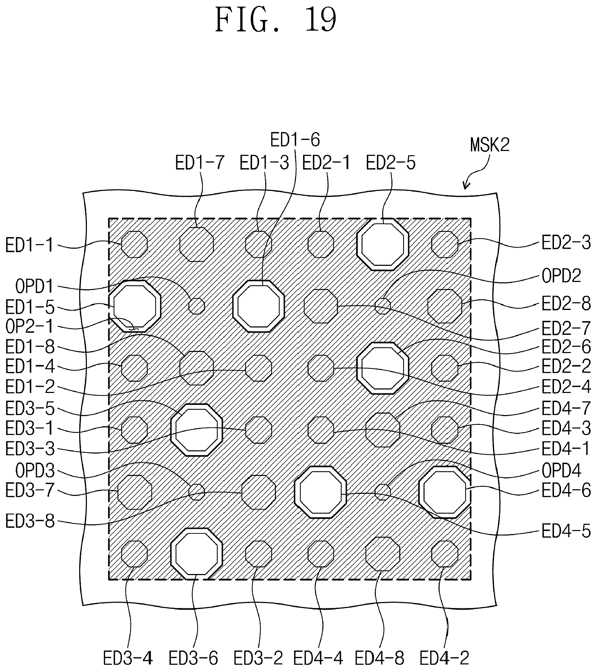

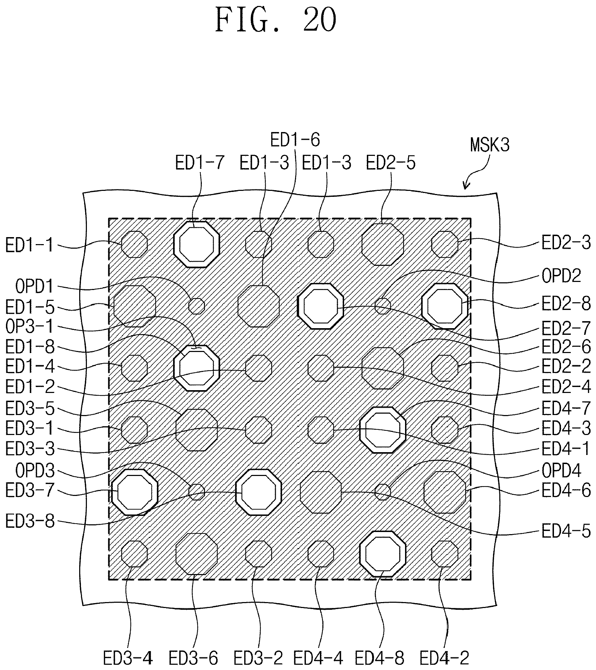

FIG. 18 is a plan view illuminating a partial region of the first mask MSK1 according to an embodiment of the disclosure, FIG. 19 is a plan view illustrating a partial region of the second mask MSK2 according to an embodiment of the disclosure, and FIG. 20 is a plan view illustrating a partial region of the third mask MSK3 according to an embodiment of the disclosure.

Referring to FIG. 18, the first mask MSK1 may include a (1-1)-th opening part OP1-1 and a (1-2)-th opening part OP1-2.

The (1-1)-th opening parts OP1-1 of the first mask MSK1 may have a shape corresponding to the light emitting devices ED1-1 to ED1-4, ED2-1 to ED2-4, ED3-1 to ED3-4, and ED4-1 to ED4-4 that emit the first color light. The first auxiliary layer SOL-1 (see FIG. 8) of four adjacent light emitting devices of the light emitting devices ED1-1 to ED1-4, ED2-1 to ED2-4, ED3-1 to ED3-4, and ED4-1 to ED4-4 that emit the first color light may correspond to one hole including the four light emitting devices.

For example, the (1-2)-th light emitting device ED1-2, the (2-4)-th light emitting device ED2-4, the (3-3)-th light emitting device ED3-3, and the (4-1)-th light emitting device ED4-1 may correspond to the (1-1)-th opening part OP1-1. As described above, the light emitting devices ED1-1 to ED1-4, ED2-1 to ED2-4, ED3-1 to ED3-4, and ED4-1 to ED4-4 that emit the first color light may be disposed adjacent to each other, and the first auxiliary layer SOL-1 of the light emitting devices adjacent to each other may be formed in one hole.

In case that individual opening parts corresponding to each of the light emitting devices ED1-1 to ED1-4, ED2-1 to ED2-4, ED3-1 to ED3-4, and ED4-1 to ED4-4 are formed in the first mask MSK1, a spacing may not be ensured between the opening parts for the ribs of the mask. Accordingly, according to an embodiment, in case that the auxiliary layers SOL-1 of adjacent light emitting devices correspond to one (1-1)-th opening part OP1-1, it is unnecessary to ensure the ribs of the masks. Accordingly, even in case that the spacing between the light emitting devices is narrow, the auxiliary layer may be deposited.

The (1-2)-th opening parts OP1-2 of the first mask MSK1 may have the shapes corresponding to the first to fourth light receiving devices OPD1 to OPD4. A minimum distance R1 between the (1-1)-th opening part OP1-1 and the (1-2)-th opening part OP1-2 may be greater than the minimum distance for ensuring the ribs of the masks.

Referring to FIG. 19, the second mask MSK2 may include (2-1)-th opening parts OP2-1.

The (2-1)-th opening parts OP2-1 may have shapes corresponding to the light emitting devices ED1-5, ED1-6, ED2-5, ED2-6, ED3-5, ED3-6, ED4-5, and ED4-6, which emit the second color light. The light emitting devices ED1-5, ED1-6, ED2-5, ED2-6, ED3-5, ED3-6, ED4-5, and ED4-6, which emit the second color light and are not disposed adjacent to each other, may have independent (2-1)-th opening parts OP2-1, which are different from the light emitting devices ED1-1 to ED1-4, ED2-1 to ED2-4, ED3-1 to ED3-4, and ED4-1 to ED4-4 that emit the first color light.

Referring to FIG. 20, the third mask MSK3 may include (3-1)-th opening parts OP3-1.

The (3-1)-th opening parts OP3-1 may have shapes corresponding to the light emitting devices ED1-7, ED1-8, ED2-7, ED2-8, ED3-7, ED3-8, ED4-7, and ED4-8, which emit the third color light. The light emitting devices ED1-7, ED1-8, ED2-7, ED2-8, ED3-7, ED3-8, ED4-7, and ED4-8, which emit the third color light, and are not disposed adjacent to each other, may have independent (3-1)-th opening parts OP3-1, which are different from the light emitting devices ED1-1 to ED1-4, ED2-1 to ED2-4, ED3-1 to ED3-4, and ED4-1 to ED4-4 that emit the first color light.

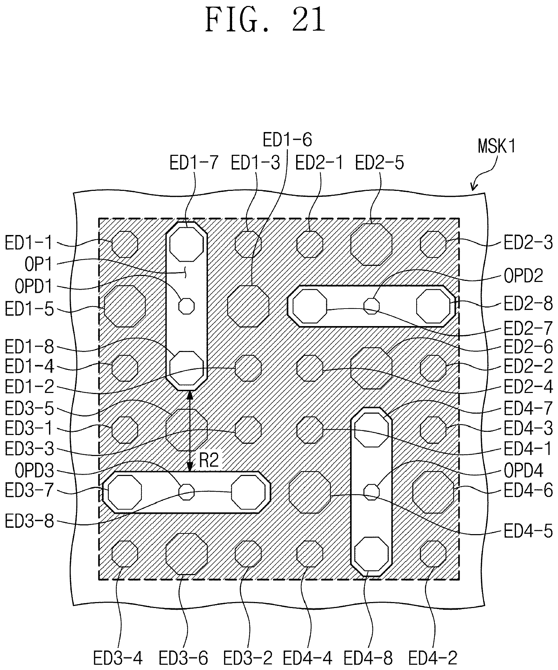

FIG. 21 is a plan view illustrating a partial region of a first mask, according to an embodiment of the disclosure.

FIG. 21 illustrates a shape of the first mask MSK1 that is used for simultaneously depositing the auxiliary layers SOL-3 and SOL-4 (see FIG. 10) of the light receiving devices OPD1 to OPD4, and the light emitting devices ED1-7, ED1-8, ED2-7, ED2-8, ED3-7, ED3-8, ED4-7, and ED4-8 that emit the third color light (S21) on the working substrate WS. This is provided only for the illustrative purpose of the disclosure. For example, the auxiliary layers SOL-2 and SOL-4 of the light receiving devices OPD1 to OPD4, and the light emitting devices ED1-5, ED1-6, ED2-5, ED2-6, ED3-5, ED3-6, ED4-5, and ED4-6 may be simultaneously deposited.

The first opening parts OP1, also called as first opening holes OP1, of the first mask MSK1 may have the shapes corresponding to the light receiving devices OPD1 to OPD4 and the light emitting devices ED1-7, ED1-8, ED2-7, ED2-8, ED3-7, ED3-8, ED4-7, and ED4-8 that emit the third color light. The auxiliary layers SOL-3 and SOL-4 of adjacent devices of the light receiving devices OPD1 to OP4 and the light emitting devices ED1-7, ED1-8, ED2-7, ED2-8, ED3-7, ED3-8, ED4-7, and ED4-8, which emit the third color light, may correspond to one first opening part OP1.

For example, the (1-7)-th light emitting device ED1-7, the first light receiving device OPD1, and the (1-8)-th light emitting device ED1-8, which are disposed adjacent each other, may correspond to one first opening part OP1. For example, the (2-7)-th light emitting device ED2-7, the second light receiving device OPD2, and the (2-8)-th light emitting device ED2-8, which are disposed adjacent each other, may correspond to another first opening part OP1. The first opening parts OP1 may have a same shape extending in different directions.

The shape of the first mask MSK1 is provided only for the illustrative purpose. For example, the shape of the first mask MSK1 may be identically applied, even in case that the first opening parts OP1 have the shapes corresponding to the light receiving devices OPD1 to OPD4, and the light emitting devices ED1-5, ED1-6, ED2-5, ED2-6, ED3-5, ED3-6, ED4-5, and ED4-6 that emit the second color light.

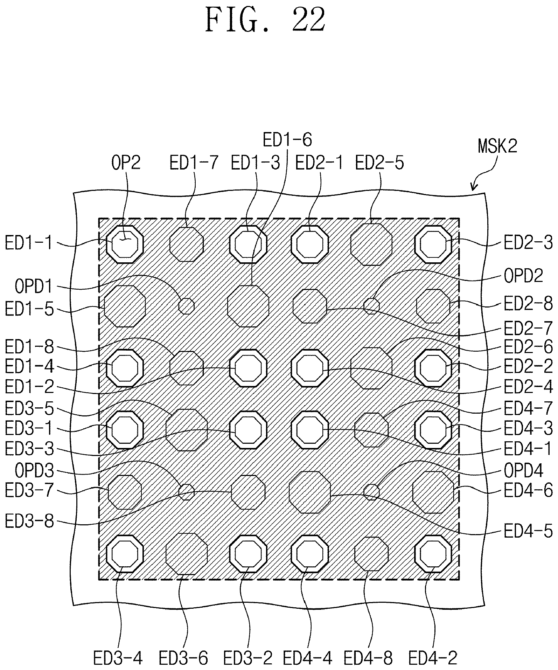

FIG. 22 is a plan view illustrating a partial region of a second mask according to an embodiment of the disclosure.

Referring to FIG. 22, the second mask MSK2 may include second opening parts OP2, also called as second opening holes OP2. The second opening parts OP2 may have shapes corresponding to the light emitting devices ED1-1 to ED1-4, ED2-1 to ED2-4, ED3-1 to ED3-4, and ED4-1 to ED4-4 which emit the first color light.

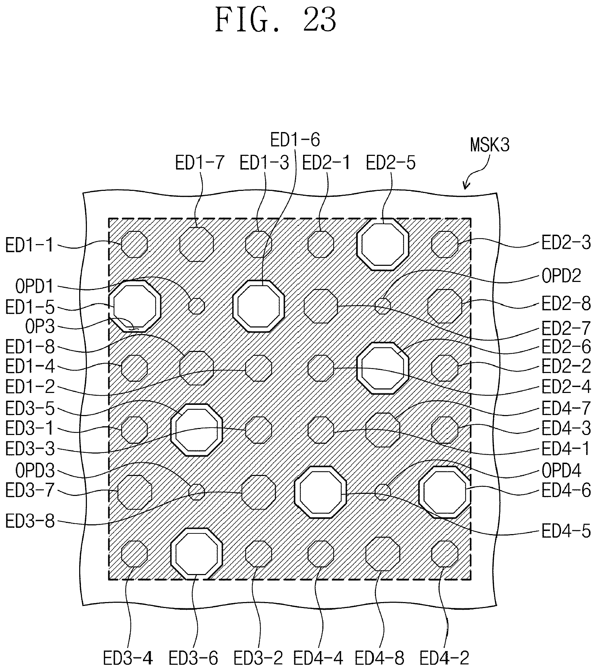

FIG. 23 is a plan view illustrating a partial region of a third mask according to an embodiment of the disclosure.

Referring to FIG. 23, the third mask MSK3 may include third opening parts OP3. The third opening parts OP3 may have shapes corresponding to the light emitting devices ED1-5, ED1-6, ED2-5, ED2-6, ED3-5, ED3-6, ED4-5, and ED4-6 which emit the second color light. The light emitting devices ED1-5, ED1-6, ED2-5, ED2-6, ED3-5, ED3-6, ED4-5, and ED4-6, which emit the second color light and are not disposed adjacent to each other, may have independent third opening parts OP3, which are different from the light emitting devices ED1-1 to ED1-4, ED2-1 to ED2-4, ED3-1 to ED3-4, and ED4-1 to ED4-4 that emit the first color light.

As described above, according to embodiments of the disclosure, the display panel may prevent a process margin from being reduced or a resolution from being degraded, by efficiently arranging light emitting devices and light receiving devices in the first unit pixel to the fourth unit pixel.

According to embodiments of the disclosure, in the method for manufacturing the display panel, the process of forming the auxiliary layers of the light emitting device and the light receiving device may be simplified by simultaneously depositing the auxiliary layers of the light emitting device and the light receiving device.

The above description is an example of technical features of the disclosure, and those skilled in the art to which the disclosure pertains will be able to make various modifications and variations. Thus, the embodiments of the disclosure described above may be implemented separately or in combination with each other.

## Claims

1. A display panel (DP) comprising:
a first unit pixel (UN1); and
a second unit pixel (UN2) disposed adjacent to the first unit pixel (UN1) in a first direction (DR1), wherein
the first unit pixel (UN1) includes:
a first light receiving device (OPD1);
a (1-1)-th light emitting device (ED1-1) and a (1-2)-th light emitting device (ED1-2), each emitting first color light and disposed in a first diagonal direction (XR1) from the first light receiving device (OPD1), the first light receiving device (OPD1) disposed between the (1-1)-th light emitting device (ED1-1) and the (1-2)-th light emitting device (ED1-2);
a (1-3)-th light emitting device (ED1-3) and a (1-4)-th light emitting device (ED1-4), each emitting the first color light and disposed in a second diagonal direction (XR2) intersecting the first diagonal direction (XR1) from the first light receiving device (OPD1), the first light receiving device (OPD1) disposed between the (1-3)-th light emitting device (ED1-3) and the (1-4)-th light emitting device (ED1-4);
a (1-5)-th light emitting device (ED1-5) and a (1-6)-th light emitting device (ED1-6), each emitting second color light, disposed in the first direction (DR1) from the first light receiving device (OPD1), and interposed between two of the (1-1)-th light emitting device (ED1-1) to the (1-4)-th light emitting device (ED1-4), which are arranged in a second direction (DR2) intersecting the first direction (DR1), the first light receiving device (OPD1) disposed between the (1-5)-th light emitting device (ED1-5) and the (1-6)-th light emitting device (ED1-6); and
a (1-7)-th light emitting device (ED1-7) and a (1-8)-th light emitting device (ED1-8), each emitting third color light, disposed in the second direction (DR2) from the first light receiving device (OPD1), and interposed between two of the (1-1)-th light emitting device (ED1-1) to the (1-4)-th light emitting device (ED1-4), which are arranged in the first direction (DR1), the first light receiving device (OPD1) disposed between the (1-7)-th light emitting device (ED1-7) and the (1-8)-th light emitting device (ED 1-8),
the second unit pixel (UN2) includes:
a second light receiving device (OPD2);
a (2-1)-th light emitting device (ED2-1) and a (2-2)-th light emitting device (ED2-2), each emitting the first color light and disposed in the first diagonal direction (XR1) from the second light receiving device (OPD2), the second light receiving device (OPD2) disposed between the (2-1)-th light emitting device (ED2-1) and the (2-2)-th light emitting device (ED2-2);
a (2-3)-th light emitting device (ED2-3) and a (2-4)-th light emitting device (ED2-4), each emitting the first color light and disposed in the second diagonal direction (XR2) from the second light receiving device (OPD2), the second light receiving device (OPD2) disposed between the (2-3)-th light emitting device (ED2-3) and the (2-4)-th light emitting device (ED2-4);
a (2-5)-th light emitting device (ED2-5) and a (2-6)-th light emitting device (ED2-6), each emitting the second color light, disposed in the second direction (DR2) from the second light receiving device (OPD2), and interposed between two of the (2-1)-th light emitting device (ED2-1) to the (2-4)-th light emitting device (ED2-4), which are arranged in the first direction (DR1), the second light receiving device (OPD2) disposed between the (2-5)-th light emitting device (ED2-5) and the (2-6)-th light emitting device (ED2-6); and
a (2-7)-th light emitting device (ED2-7) and a (2-8)-th light emitting device (ED2-8), each emitting the third color light, disposed in the first direction (DR1) from the second light receiving device (OPD2), and interposed between two of the (2-1)-th light emitting device (ED2-1) to the (2-4)-th light emitting device (ED2-4),
which are arranged in the second direction (DR2), the second light receiving device (OPD2) disposed between the (2-7)-th light emitting device (ED2-7) and the (2-8)-th light emitting device (ED2-8),
the (1-2)-th light emitting device (ED1-2) is disposed more adjacent to the second unit pixel (UN2) than the (1-1)-th light emitting device (ED1-1), and
one of the (2-3)-th light emitting device (ED2-3) and the (2-4)-th light emitting device (ED2-4) is disposed most adjacent to the (1-2)-th light emitting device (ED1-2) among the light emitting devices in the second unit pixel (UN2).

2. The display panel (DP) of claim 1, wherein
the (1-6)-th light emitting device (ED1-6) is disposed more adjacent to the second unit pixel (UN2) than the (1-5)-th light emitting device (ED1-5), and
one of the (2-7)-th light emitting device (ED2-7) and the (2-8)-th light emitting device (ED2-8) is disposed most adjacent to the (1-6)-th light emitting device (ED1-6), among the light emitting devices in the second unit pixel (UN2).

3. The display panel (DP) of claim 1 or 2, wherein a number of the first light receiving device (OPD1) is 1/4 times of a number of the light emitting devices emitting the first color light in the first unit pixel (UN1).

4. The display panel (DP) of ate least one of claims 1 to 3, wherein
the (1-1)-th light emitting device (ED1-1) is spaced apart from the first light receiving device (OPD1) by a first spacing (L1),
the (1-5)-th light emitting device (ED1-5) is spaced apart from the first light receiving device (OPD1) by a second spacing (L2),
the (1-7)-th light emitting device (ED1-7) is spaced apart from the first light receiving device (OPD1) by a third spacing (L3), and
the first spacing (L1) is greater than the second spacing (L2) and the third spacing (L3).

5. The display panel of claim 4, wherein the (1-1)-th light emitting device (ED1-1) to the (1-4)-th light emitting device (ED1-4) are spaced apart from the first light receiving device (OPD1) by the first spacing (L1).

6. The display panel (DP) of at least one of claims 1 to 5, wherein distances between centers of most adjacent ones of the first light receiving device (OPD1) and the (1-1)-th light emitting device (ED1-1) to the (1-8)-th light emitting device (ED1-8) are same, in the first unit pixel (UN1).

7. The display panel (DP) of at least one of claims 1 to 6, wherein the (1-5)-th light emitting device (ED1-5) and the (1-6)-th light emitting device (ED1-6) are symmetrical to each other with respect to the first light receiving device (OPD1).

8. The display panel (DP) of at least one of claims 1 to 7, wherein the (1-7)-th light emitting device (ED1-7) and the (1-8)-th light emitting device (ED1-8) are symmetrical to each other with respect to the first light receiving device (OPD1).

9. The display panel (DP) of at least one of claims 1 to 8, wherein a number of the first light receiving device (OPD1) is 1/2 times of a number of the light emitting devices emitting the second color light in the first unit pixel (UN1).

10. The display panel (DP) of at least one of claims 1 to 9, wherein
each of the (1-1)-th light emitting device (ED1-1) to the (1-8)-th light emitting device (ED1-8) includes a first electrode (AE), a hole transfer region (HTR), an auxiliary layer (SOL-1 to SOL-3), a light emitting layer (EML-1 to EML-3), an electron transfer region (ETR), and a second electrode (CE) sequentially stacked, and
each of the first and second light receiving devices (OPD1, OPD2) includes a first electrode (AE), a hole transfer region (HTR), an auxiliary layer (SOL-1 to SOL-3), a light receiving layer (OPL), an electron transfer region (ETR), and a second electrode (CE) sequentially stacked.

11. The display panel (DP) of claim 10, wherein the auxiliary layer (SOL-1) of each of the (1-1)-th light emitting device (ED1-1) to the (1-4)-th light emitting device (ED1-4) and the auxiliary layer (SOL-1 to SOL-3) of each of the first and second light receiving device (OPD1, OPD2) are integral with each other.

12. The display panel of claim 10 or 11, wherein the auxiliary layer (SOL-1 to SOL-3) of each of the (1-5)-th light emitting device (ED1-5) and the (1-6)-th light emitting device (ED1-6) or the auxiliary layer (SOL-1 to SOL-3) of each of the (1-7)-th light emitting device (ED1-7) and the (1-8)-th light emitting device (ED1-8), and the auxiliary layer (SOL-1 to SOL-3) of each the first and second light receiving device (OPD1, OPD2) are integral with each other.

13. The display panel (DP) of at least one of claims 10 to 12, further comprising:
a pixel defining layer (PDL) having an opening part (OH) exposing the first electrode (AE) of each of the (1-1)-th light emitting device (ED1-1) to the (1-8)-th light emitting device (ED1-8), and
wherein the opening part (OH) exposing the first electrode (AE) of at least one of the (1-1)-th light emitting device (ED1-1) to the (1-8)-th light emitting device (ED1-8) has a substantially octagonal shape in a plan view.

14. The display panel (DP) of at least one of claims 1 to 13, further comprising:
a third unit pixel (UN3) disposed adjacent to the first unit pixel (UN1) in the second direction (DR2); and
a fourth unit pixel disposed adjacent to the second unit pixel (UN2) in the second direction (DR2), wherein
the third unit pixel (UN3) includes:
a third light receiving device (OPD3);
a (3-1)-th light emitting device (ED3-1) and a (3-2)-th light emitting device (ED3-2), each emitting the first color light and disposed in the first diagonal direction (XR1) from the third light receiving device (OPD3), the third light receiving device (OPD3) disposed between the (3-1)-th light emitting device (ED3-1) and the (3-2)-th light emitting device (ED3-2);
a (3-3)-th light emitting device (ED3-3) and a (3-4)-th light emitting device (ED3-4), each emitting the first color light and disposed in the second diagonal direction (XR2) from the third light receiving device (OPD3), the third light receiving device (OPD3) disposed between the (3-3)-th light emitting device (ED3-3) and the (3-4)-th light emitting device (ED3-4);
a (3-5)-th light emitting device (ED3-5) and a (3-6)-th light emitting device (ED3-6), each emitting the second color light, disposed in the second direction (DR2) from the third light receiving device (OPD3), and interposed between two of the (3-1)-th light emitting device (ED3-1) to the (3-4)-th light emitting device (ED3-4), which are arranged in the first direction (DR1), the third light receiving device (OPD3) disposed between the (3-5)-th light emitting device (ED3-5) and the (3-6)-th light emitting device (ED3-6); and
a (3-7)-th light emitting device (ED3-7) and a (3-8)-th light emitting device (ED3-8), each emitting the third color light, disposed in the first direction (DR1) from the third light receiving device (OPD3), and interposed between two of the (3-1)-th light emitting device (ED3-1) to the (3-4)-th light emitting device (ED3-4), which are arranged in the second direction (DR2), the third light receiving device (OPD3) disposed between the (3-7)-th light emitting device (ED3-7) and the (3-8)-th light emitting device (ED3-8), and
the fourth unit pixel (UN4) includes:
a fourth light receiving device (OPD4);
a (4-1)-th light emitting device (ED4-1) and a (4-2)-th light emitting device (ED4-2), each emitting the first color light and disposed in the first diagonal direction (XR1) from the fourth light receiving device (OPD4), the fourth light receiving device (OPD4) disposed between the (4-1)-th light emitting device (ED4-1) and the (4-2)-th light emitting device (ED4-2);
a (4-3)-th light emitting device (ED4-3) and a (4-4)-th light emitting device (ED4-4), each emitting the first color light and disposed in the second diagonal direction (XR2) from the fourth light receiving device (OPD4), the fourth light receiving device (OPD4) disposed between the (4-3)-th light emitting device (ED4-3) and the (4-4)-th light emitting device (ED4-4);
a (4-5)-th light emitting device (ED4-5) and a (4-6)-th light emitting device (ED4-6), each emitting the second color light, disposed in the first direction (DR1) from the fourth light receiving device (OPD4), the fourth light receiving device (OPD4) between the (4-5)-th light emitting device (ED4-5) and the (4-6)-th light emitting device (ED4-6), and interposed between two of the (4-1)-th light emitting device (ED4-1) to the (4-4)-th light emitting device (ED4-4), which are arranged in the second direction (DR2), the fourth light receiving device (OPD4) disposed between the (4-5)-th light emitting device (ED4-5) and the (4-6)-th light emitting device (ED4-6); and
a (4-7)-th light emitting device (ED4-7) and a (4-8)-th light emitting device (ED4-8), each emitting the third color light, disposed in the second direction (DR2) from the fourth light receiving device (OPD4), and interposed between two of the (4-1)-th light emitting device (ED4-1) to the (4-4)-th light emitting device (ED4-4), which are arranged in the first direction (DR1), the fourth light receiving device (OPD4) disposed between the (4-7)-th light emitting device (ED4-7) and the (4-8)-th light emitting device (ED4-8).

15. The display panel (DP) of claim 14, wherein
the (3-3)-th light emitting device (ED3-3) is disposed more adjacent to the fourth unit pixel (UN4) than the (3-4)-th light emitting device (ED3-4), and
one of the (4-1)-th light emitting device (ED4-1) and the (4-2)-th light emitting device (ED4-2) is disposed most adjacent to the (3-3)-th light emitting device (ED3-3), among the light emitting devices in the fourth unit pixel (UN4).

16. The display panel (DP) of claim 14 or 15, wherein light emitting device, which is most adjacent to light emitting devices emitting the second light in the first unit pixel (UN1) to the fourth unit pixel (UN4), emits the first color light or third color light.

17. A method for manufacturing a display panel (DP), in particular a display panel (DP) of at least one of claims 1 to 16, which includes a first unit pixel (UN1), a second unit pixel (UN2) disposed adjacent to the first unit pixel (UN1) in a first direction (DR1), a third unit pixel (UN3) disposed adjacent to the first unit pixel (UN1) in a second direction (DR2) intersecting the first direction (DR1), and a fourth unit pixel (UN4) disposed adjacent to the second unit pixel (UN2) in the second direction (DR2), wherein the first unit pixel (UN1) includes a first light receiving device (OPD1), a (1-1)-th light emitting device (ED1-1) and a (1-2)-th light emitting device (ED1-2), each emitting first color light and disposed in a first diagonal direction (XR1) from the first light receiving device (OPD1), the first light receiving device (OPD1) disposed between the (1-1)-th light emitting device (ED1-1) and the (1-2)-th light emitting device (ED1-2), a (1-3)-th light emitting device (ED1-3) and a (1-4)-th light emitting device (ED1-4), each emitting the first color light and disposed in a second diagonal direction (XR2) intersecting the first diagonal direction (XR1) from the first light receiving device (OPD1), the first light receiving device (OPD1) disposed between the (1-3)-th light emitting device (ED1-3) and the (1-4)-th light emitting device (ED1-4), a (1-5)-th light emitting device (ED1-5) and a (1-6)-th light emitting device (ED1-6), each emitting second color light, disposed in the first direction (DR1) from the first light receiving device (OPD1) the first light receiving device (OPD1) between the (1-5)-th light emitting device (ED1-5) and the (1-6)-th light emitting device (ED1-6), and interposed between two of the (1-1)-th light emitting device (ED1-1) to the (1-4)-th light emitting device (ED1-4), which are arranged in the second direction (DR2), the first light receiving device (OPD1) disposed between the (1-5)-th light emitting device (ED1-5) and the (1-6)-th light emitting device (ED1-6), and a (1-7)-th light emitting device (ED1-7) and a (1-8)-th light emitting device (ED1-8), each emitting third color light, disposed in the second direction (DR2) from the first light receiving device (OPD1), and interposed between two of the (1-1)-th light emitting device (ED1-1) to the (1-4)-th light emitting device (ED1-4), which are arranged in the first direction (DR1), the first light receiving device (OPD1) disposed between the (1-7)-th light emitting device (ED1-7) and the (1-8)-th light emitting device (ED1-8), and the second unit pixel (UN2) includes a second light receiving device (OPD2), a (2-1)-th light emitting device (ED2-1) and a (2-2)-th light emitting device (ED2-2), each emitting the first color light and disposed in the first diagonal direction (XR1) from the second light receiving device (OPD2), the second light receiving device (OPD2) disposed between the (2-1)-th light emitting device (ED2-1) and the (2-2)-th light emitting device (ED2-2), a (2-3)-th light emitting device (ED2-3) and a (2-4)-th light emitting device (ED2-4), each emitting the first color light and disposed in the second diagonal direction (XR2) from the second light receiving device (OPD2), the second light receiving device (OPD2) disposed between the (2-3)-th light emitting device (ED2-3) and the (2-4)-th light emitting device (ED2-4), a (2-5)-th light emitting device (ED2-5) and a (2-6)-th light emitting device (ED2-6), each emitting the second color light, disposed in the second direction (DR2) from the second light receiving device (OPD2), and interposed between two of the (2-1)-th light emitting device (ED2-1) to the (2-4)-th light emitting device (ED2-4), which are arranged in the first direction (DR1), the second light receiving device disposed between the (2-5)-th light emitting device (ED2-5) and the (2-6)-th light emitting device (ED2-6), and a (2-7)-th light emitting device (ED2-7) and a (2-8)-th light emitting device (ED2-8), each emitting the third color light, disposed in the first direction (DR1) from the second light receiving device (OPD2), and interposed between two of the (2-1)-th light emitting device (ED2-1) to the (2-4)-th light emitting device (ED2-4), which are arranged in the second direction (DR2), the second light receiving device (OPD2) disposed between the (2-7)-th light emitting device (ED2-7) and the (2-8)-th light emitting device (ED2-8),
the method comprising:
providing a working substrate (WS) including light receiving electrodes of the first light receiving device (OPD1) and the second light receiving device (OPD2), first electrodes (AE) of the (1-1)-th light emitting device (ED1-1) to the (1-8)-th light emitting device (ED1-8), and first electrodes (AE) of the (2-1)-th light emitting device (ED2-1) to the (2-8)-th light emitting device (ED2-8);
depositing, each of auxiliary layers (SOL-1 to SOL-3) of the first light receiving device (OPD1) and the second light receiving device (OPD2) on each of the light receiving electrodes, and depositing each of auxiliary layers (SOL-1 to SOL-3) of the (1-1)-th light emitting device (ED1-1) to the (1-4)-th light emitting device (ED1-4) and the (2-1)-th light emitting device (ED2-1) to the (2-4)-th light emitting device (ED2-4) on each of the first electrodes (AE), by using a first mask (MSK1);
simultaneously depositing, on the first electrodes (AE) on the working substrate (WS), auxiliary layers (SOL-1) of the (1-5)-th light emitting device (ED1-5), the (1-6)-th light emitting device (ED1-6), the (2-5)-th light emitting device (ED2-5), and the (2-6)-th light emitting device (ED2-6) by using a second mask (MSK2); and
simultaneously depositing, on the first electrodes (AE) on the working substrate (WS), auxiliary layers (SOL-1 to SOL-3) of the (1-7)-th light emitting device (ED1-7), the (1-8)-th light emitting device (ED1-8), the (2-7)-th light emitting device (ED2-7), and the (2-8)-th light emitting device (ED2-8) by using a third mask (MSK3).

18. The method of claim 17, wherein
the first mask (MSK1) includes:
first opening parts (OP1) corresponding to each of the first light receiving device (OPD1) and the second light receiving device (OPD2); and
second opening parts (OP2) spaced apart from the first opening parts (OP1), and
the second opening parts (OP2) correspond to the (1-1)-th light emitting device (ED1-1) to the (1-4)-th light emitting device (ED1-4) in the first unit pixel (UN1), and the (2-1)-th light emitting device (ED2-1) to the (2-4)-th light emitting device (ED2-4) in the second unit pixel (UN2).

19. A method for manufacturing a display panel (DP), in particular a display panel (DP) of at least one of claims 1 to 16, which includes a first unit pixel (UN1), a second unit pixel (UN2) disposed adjacent to the first unit pixel (UN1) in a first direction (DR1), a third unit pixel (UN3) disposed adjacent to the first unit pixel (UN1) in a second direction (DR2) intersecting the first direction (DR1), and a fourth unit pixel (UN4) disposed adjacent to the second unit pixel (UN2) in the second direction (DR2), wherein the first unit pixel (UN1) includes a first light receiving device (OPD1), a (1-1)-th light emitting device (ED1-1) and a (1-2)-th light emitting device (ED1-2), each emitting first color light and disposed in a first diagonal direction (XR1) from the first light receiving device (OPD1), the first light receiving device (OPD1) disposed between the (1-1)-th light emitting device (ED1-1) and the (1-2)-th light emitting device (ED1-2), a (1-3)-th light emitting device (ED1-3) and a (1-4)-th light emitting device (ED1-4), each emitting the first color light and disposed in a second diagonal direction (XR2) intersecting the first diagonal direction (XR1) from the first light receiving device (OPD1), the first light receiving device (OPD1) disposed between the (1-3)-th light emitting device (ED1-3) and the (1-4)-th light emitting device (ED1-4), a (1-5)-th light emitting device (ED1-5) and a (1-6)-th light emitting device (ED1-6), each emitting second color light, disposed in the first direction (DR1) from the first light receiving device (OPD1), and interposed between two of the (1-1)-th light emitting device (ED1-1) to the (1-4)-th light emitting device (ED1-4), which are arranged in the second direction (DR2), the first light receiving device (OPD1) disposed between the (1-5)-th light emitting device (ED1-5) and the (1-6)-th light emitting device (ED1-6), and a (1-7)-th light emitting device (ED1-7) and a (1-8)-th light emitting device (ED1-8), each emitting third color light, disposed in the second direction (DR2) from the first light receiving device (OPD1), and interposed between two of the (1-1)-th light emitting device (ED1-1) to the (1-4)-th light emitting device (ED1-4), which are arranged in the first direction (DR1), the first light receiving device (OPD1) disposed between the (1-7)-th light emitting device (ED1-7) and the (1-8)-th light emitting device (ED1-8), and the second unit pixel (UN2) includes a second light receiving device (OPD2), a (2-1)-th light emitting device (ED2-1) and a (2-2)-th light emitting device (ED2-2), each emitting the first color light and disposed in the first diagonal direction (XR1) from the second light receiving device (OPD2), the second light receiving device (OPD2) disposed between the (2-1)-th light emitting device (ED2-1) and the (2-2)-th light emitting device (ED2-2), a (2-3)-th light emitting device (ED2-3) and a (2-4)-th light emitting device (ED2-4), each emitting the first color light and disposed in the second diagonal direction (XR2) from the second light receiving device (OPD2), the second light receiving device (OPD2) disposed between the (2-3)-th light emitting device (ED2-3) and the (2-4)-th light emitting device (ED2-4), a (2-5)-th light emitting device (ED2-5) and a (2-6)-th light emitting device (ED2-6), each emitting the second color light, disposed in the second direction (DR2) from the second light receiving device (OPD2), and interposed between two of the (2-1)-th light emitting device (ED2-1) and the (2-4)-th light emitting device (ED2-4), which are arranged in the first direction (DR1), the second light receiving device (OPD2) disposed between the (2-5)-th light emitting device (ED2-5) and the (2-6)-th light emitting device (ED2-6), and a (2-7)-th light emitting device (ED2-7) and a (2-8)-th light emitting device (ED2-8), each emitting the third color light, disposed in the first direction (DR1) from the second light receiving device (OPD2), and interposed between two of the (2-1)-th light emitting device (ED2-1) to the (2-4)-th light emitting device (ED2-4), which are arranged in the second direction (DR2), the second light receiving device (OPD2) disposed between the (2-7)-th light emitting device (ED2-7) and the (2-8)-th light emitting device (ED2-8),
the method comprising:
providing a working substrate (WS) including light receiving electrodes of the first light receiving device (OPD1) and the second light receiving device (OPD2), first electrodes (AE) of the (1-1)-th light emitting device (ED1-1) to the (1-8)-th light emitting device (ED1-8), and first electrodes (AE) of the (2-1)-th light emitting device (ED2-1) to the (2-8)-th light emitting device (ED2-8);
simultaneously depositing, on the light receiving electrodes and the first electrodes (AE) on the working substrate (WS), auxiliary layers of the first light receiving device (OPD1), the second light receiving device (OPD2), the (1-7)-th light emitting device (ED1-7), the (1-8)-th light emitting device (ED1-8), the (2-7)-th light emitting device (ED2-7), and the (2-8)-th light emitting device (ED2-8), by using a first mask (MSK1);
simultaneously depositing, on the first electrodes (AE) on the working substrate (WS), auxiliary layers of the (1-1)-th light emitting device (ED1-1) to the (1-4)-th light emitting device (ED1-4), and the (2-1)-th light emitting device (ED2-1) to the (2-4)-th light emitting device (ED2-4) by using a second mask (MSK2); and
simultaneously depositing, on the first electrodes (AE) on the working substrate (WS), auxiliary layers of the (1-5)-th light emitting device (ED1-5), the (1-6)-th light emitting device (ED1-6), the (2-5)-th light emitting device (ED2-5), and the (2-6)-th light emitting device (ED2-6) by using a third mask (MSK3).

20. The method of claim 19, wherein the first mask (MSK1) includes:
a first opening hole (OP1) corresponding to the first light receiving device (OPD1), the (1-7)-th light emitting device (ED1-7), and the (1-8)-th light emitting device (ED1-8); and
a second opening hole (OP2) corresponding to the second light receiving device (OPD2), the (2-7)-th light emitting device (ED2-7), and the (2-8)-th light emitting device (ED2-8), and
wherein the first opening hole (OP1) and the second opening hole (OP2) have a same shape in a plan view.
